# EUROPEAN PATENT APPLICATION

(11) **EP 3 872 883 A1**
(43) Date of publication of application: **01.09.2021**
(21) Application number: 19876763.4
(22) Date of filing: 05.09.2019
(51) Int. Cl.: H01L 51/50, C08G 61/12, C09K 11/06, H05B 33/12

(54) **LIGHT-EMITTING ELEMENT**

(30) Priority: 25.10.2018 JP 2018200628
(71) Applicant: SUMITOMO CHEMICAL COMPANY LIMITED, Chuo-ku Tokyo 104-8260 (JP)
(72) Inventor: SASADA, Toshiaki, Tsukuba-shi, Ibaraki 300-3294 (JP); INAKAZU, Shinichi, Tsukuba-shi, Ibaraki 300-3294 (JP); ISHII, Yusuke, Tsukuba-shi, Ibaraki 300-3294 (JP)
(74) Representative: J A Kemp LLP
(86) International application number: PCT/JP2019/034951
(87) International publication number: WO 2020/084923

(57) **Abstract**

To provide a light emitting device excellent in light emission efficiency.

A light emitting device having an anode, a cathode, a first layer disposed between the anode and the cathode, and a second layer disposed between the anode and the first layer, wherein the second layer is a layer containing a crosslinked product of a compound having a crosslinkable group selected from Group A of crosslinkable group, and at least one of the first layer and the second layer contains a compound represented by the formula (T-1); and the light emitting device wherein the compound having a crosslinkable group selected from Group A of crosslinkable group is a polymer compound having a crosslinkable group selected from Group A of crosslinkable group:

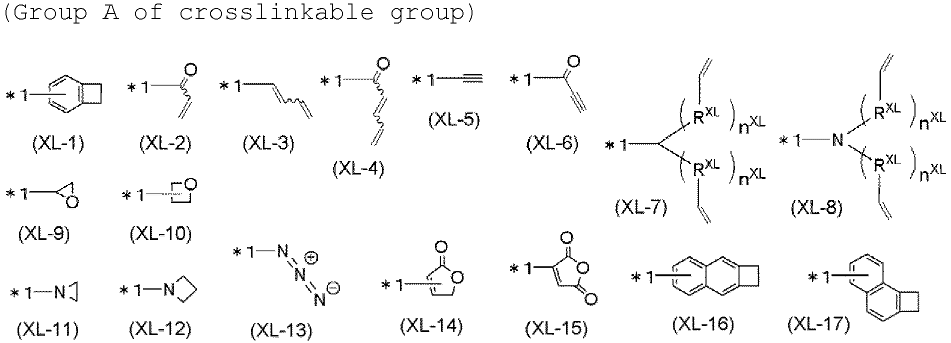

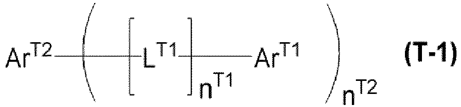

## Description

### Technical Field

The present invention relates to a light emitting device.

### Background Art

Light emitting devices such as an organic electroluminescent device and the like can be suitably used for applications of display and illumination and are being researched and developed. For example, Patent Document 1 describes a light emitting device having a crosslinked hole transporting layer formed using a compound HTL0, a light emitting layer, and an electron transporting layer containing a compound ET1.

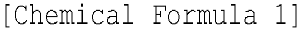

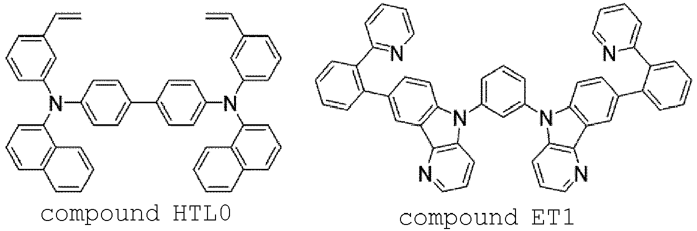

### [Prior Art Document]

### [Patent Document]

[Patent Document 1] International Publication WO2012/173079

### Summary of the Invention

### Problem to be Solved by the Invention

However, the light emission efficiency of the light emitting device described above is not necessarily sufficient.

Then, the present invention has an object of providing a light emitting device excellent in light emission efficiency.

### Means for Solving the Problem

The present invention provides the following [1] to [15] .
[1] A light emitting device having an anode, a cathode, a first layer disposed between the above-described anode and the above-described cathode, and a second layer disposed between the above-described anode and the above-described first layer, wherein
   the above-described second layer is a layer containing a crosslinked product of a compound having a crosslinkable group selected from Group A of crosslinkable group, and
   at least one of the above-described first layer and the above-described second layer contains a compound represented by the formula (T-1):
   (Group A of crosslinkable group) 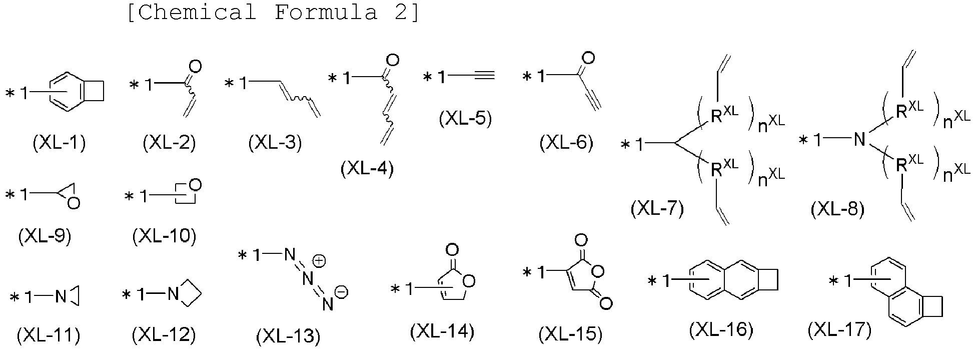 [wherein, R^{XL} represents a methylene group, an oxygen atom or a sulfur atom, n^{XL} represents an integer of 0 to 5. When a plurality of R^{XL} are present, they may be the same or different. When a plurality of n^{XL} are present, they may be the same or different. *1 represents a binding position. These crosslinkable groups optionally have a single or a plurality of substituents, and when a plurality of the substituents are present, they may be the same or different and may be combined together to form a ring together with carbon atoms to which they are attached.] 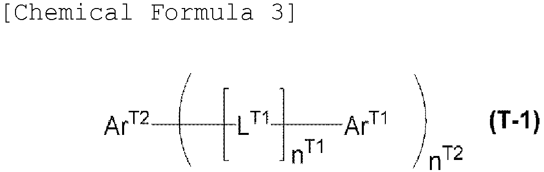 [wherein,
   n^{T1} represents an integer of 0 or more and 5 or less. when a plurality of n^{T1} are present, they may be the same or different.
   n^{T2} represents an integer of 1 or more and 10 or less.
   Ar^{T1} is a condensed monovalent hetero ring group containing a nitrogen atom having no double bond and a group represented by =N- in the ring, and the group (condensed monovalent hetero ring group) optionally has a single or a plurality of substituents, and when a plurality of the above-described substituents are present, they may be the same or different and may be combined together to form a ring together with atoms to which they are attached. When a plurality of Ar^{T1} are present, they may be the same or different.
   L^{T1} represents an alkylene group, a cycloalkylene group, an arylene group, a divalent hetero ring group, a group represented by -NR^{T1}'-, an oxygen atom or a sulfur atom, and these groups optionally have a single or a plurality of substituents, and when a plurality of the above-described substituents are present, they may be the same or different and may be combined together to form a ring together with atoms to which they are attached. R^{T1}' represents a hydrogen atom, an alkyl group, a cycloalkyl group, an aryl group or a monovalent hetero ring group, and these groups optionally have a single or a plurality of substituents, and when a plurality of the above-described substituents are present, they may be the same or different and may be combined together to form a ring together with atoms to which they are attached. When a plurality of L^{T1} are present, they may be the same or different.
   Ar^{T2} represents an aromatic hydrocarbon group or a hetero ring group, and these groups optionally have a single or a plurality of substituents, and when a plurality of the above-described substituents are present, they may be the same or different and may be combined together to form a ring together with atoms to which they are attached.].
[2] The light emitting device according to [1], wherein the compound having a crosslinkable group selected from Group A of crosslinkable group described above is a polymer compound having a crosslinkable group selected from Group A of crosslinkable group described above.
[3] The light emitting device according to [2], wherein the above-described polymer compound is a polymer compound containing a crosslinkable group selected from Group A of crosslinkable group described above as a crosslinkable constitutional unit having a crosslinkable group selected from Group A of crosslinkable group described above, and
   the above-described crosslinkable constitutional unit is a constitutional unit represented by the formula (Z) or the formula (Z'): 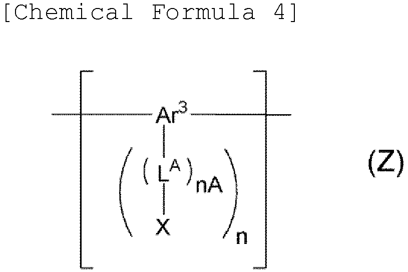 [wherein,
   n represents an integer of 1 or more.
   nA represents an integer of 0 or more. When a plurality of nA are present, they may be the same or different.
   Ar³ represents an aromatic hydrocarbon group, a hetero ring group, or a group in which at least one aromatic hydrocarbon group and at least one hetero ring group are bonded directly, and these groups optionally have a single or a plurality of substituents. When a plurality of the above-described substituents are present, they may be the same or different and may be combined together to form a ring together with atoms to which they are attached.
   L^{A} represents an alkylene group, a cycloalkylene group, an arylene group, a divalent hetero ring group, a group represented by -N(R')-, an oxygen atom or a sulfur atom, and these groups optionally have a single or a plurality of substituents. When a plurality of the above-described substituents are present, they may be the same or different and may be combined together to form a ring together with atoms to which they are attached. R' represents a hydrogen atom, an alkyl group, a cycloalkyl group, an aryl group or a monovalent hetero ring group, and these groups optionally have a single or a plurality of substituents. When a plurality of the above-described substituents are present, they may be the same or different and may be combined together to form a ring together with atoms to which they are attached. When a plurality of L^{A} are present, they may be the same or different.
   X represents a crosslinkable group selected from Group A of crosslinkable group described above. When a plurality of X are present, they may be the same or different.] 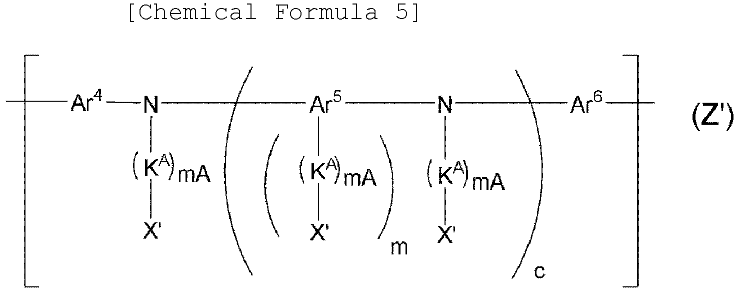
   [wherein,
   mA, m and c each independently represent an integer of 0 or more. When a plurality of mA are present, they may be the same or different. When a plurality of m are present, they may be the same or different.
   Ar⁵ represents an aromatic hydrocarbon group, a hetero ring group, or a group in which at least one aromatic hydrocarbon group and at least one hetero ring group are bonded directly, and these groups optionally have a single or a plurality of substituents. When a plurality of the above-described substituents are present, they may be the same or different and may be combined together to form a ring together with atoms to which they are attached. When a plurality of Ar⁵ are present, they may be the same or different.
   Ar⁴ and Ar⁶ each independently represent an arylene group or a divalent hetero ring group, and these groups optionally have a single or a plurality of substituents. When a plurality of the above-described substituents are present, they may be the same or different and may be combined together to form a ring together with atoms to which they are attached.
   K^{A} represents an alkylene group, a cycloalkylene group, an arylene group, a divalent hetero ring group, a group represented by -N(R")-, an oxygen atom or a sulfur atom, and these groups optionally have a single or a plurality of substituents. When a plurality of the above-described substituents are present, they may be the same or different and may be combined together to form a ring together with atoms to which they are attached. R" represents a hydrogen atom, an alkyl group, a cycloalkyl group, an aryl group or a monovalent hetero ring group, and these groups optionally have a single or a plurality of substituents. When a plurality of the above-described substituents are present, they may be the same or different and may be combined together to form a ring together with atoms to which they are attached. When a plurality of K^{A} are present, they may be the same or different.
   X' represents a crosslinkable group selected from Group A of crosslinkable group described above, a hydrogen atom, an alkyl group, a cycloalkyl group, an aryl group or a monovalent hetero ring group, and these groups optionally have a single or a plurality of substituents. When a plurality of the above-described substituents are present, they may be the same or different and may be combined together to form a ring together with atoms to which they are attached. When a plurality of X' are present, they may be the same or different. However, at least one X' is a crosslinkable group selected from Group A of crosslinkable group described above.].
[4] The light emitting device according to [1], wherein the compound having a crosslinkable group selected from Group A of crosslinkable group described above is a low-molecular compound represented by the formula (Z"): 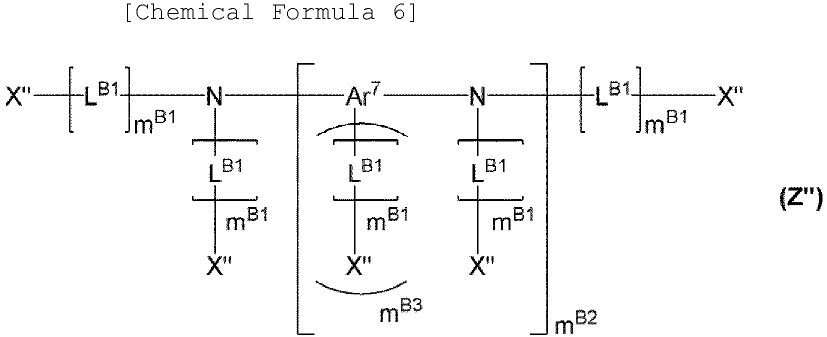 [wherein,
   m^{B1}, m^{B2} and m^{B3} each independently represent an integer of 0 or more and 10 or less. A plurality of m^{B1} may be the same or different. When a plurality of m^{B3} are present, they may be the same or different.
   Ar⁷ represents an aromatic hydrocarbon group, a hetero ring group, or a group in which at least one aromatic hydrocarbon group and at least one hetero ring group are bonded directly, and these groups optionally have a single or a plurality of substituents. When a plurality of the above-described substituents are present, they may be the same or different and may be combined together to form a ring together with atoms to which they are attached. When a plurality of Ar⁷ are present, they may be the same or different.
   L^{B1} represents an alkylene group, a cycloalkylene group, an arylene group, a divalent hetero ring group, a group represented by -N(R"')-, an oxygen atom or a sulfur atom, and these groups optionally have a single or a plurality of substituents. When a plurality of the above-described substituents are present, they may be the same or different and may be combined together to form a ring together with atoms to which they are attached. R'" represents a hydrogen atom, an alkyl group, a cycloalkyl group, an aryl group or a monovalent hetero ring group, and these groups optionally have a single or a plurality of substituents. When a plurality of the above-described substituents are present, they may be the same or different and may be combined together to form a ring together with atoms to which they are attached. When a plurality of L^{B1} are present, they may be the same or different. X" represents a crosslinkable group selected from Group A of crosslinkable group described above, a hydrogen atom, an alkyl group, a cycloalkyl group, an aryl group or a monovalent hetero ring group, and these groups optionally have a single or a plurality of substituents. When a plurality of the above-described substituents are present, they may be the same or different and may be combined together to form a ring together with atoms to which they are attached. A plurality of X" may be the same or different. However, at least one of a plurality of X" is a crosslinkable group selected from Group A of crosslinkable group described above.].
[5] The light emitting device according to any one of [1] to [4], wherein the crosslinkable group selected from Group A of crosslinkable group described above is a group represented by the above-described formula (XL-1), the above-described formula (XL-16) or the above-described formula (XL-17).
[6] The light emitting device according to any one of [1] to [5], wherein the above-described first layer contains a compound represented by the above-described formula (T-1).
[7] The light emitting device according to any one of [1] to [6], wherein the above-described Ar^{T1} is a group represented by the formula (T1-1): 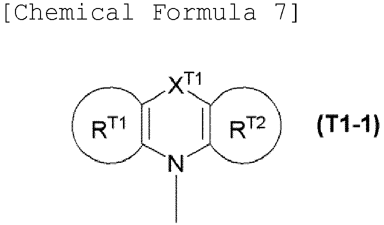 [wherein,
   X^{T1} represents a single bond, an oxygen atom, a sulfur atom, a group represented by -N(R^{XT1})-, or a group represented by -C(R^{XT1}')₂-. R^{XT1} and R^{XT1}' each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a single or a plurality of substituents, and when a plurality of the above-described substituents are present, they may be the same or different and may be combined together to form a ring together with atoms to which they are attached. A plurality of R^{XT1}' may be the same or different and may be combined together to form a ring together with atoms to which they are attached.
   Ring R^{T1} and Ring R^{T2} each independently represent an aromatic hydrocarbon ring or a hetero ring, and these rings optionally have a single or a plurality of substituents. When a plurality of the above-described substituents are present, they may be the same or different and may be combined together to form a ring together with atoms to which they are attached.
   At least one of Ring R^{T1} and Ring R^{T2} is a hetero ring containing a group represented by =N- in the ring and the ring optionally has a single or a plurality of substituents, and when a plurality of the above-described substituents are present, they may be the same or different and may be combined together to form a ring together with atoms to which they are attached.].
[8] The light emitting device according to [7], wherein the above-described Ring R^{T1} is an aromatic hydrocarbon ring or a hetero ring containing a group represented by =N- in the ring and these rings optionally have a single or a plurality of substituents, and the above-described Ring R^{T2} is a hetero ring containing a group represented by =N- in the ring and the ring optionally has a single or a plurality of substituents.
[9] The light emitting device according to [8], wherein the above-described Ring R^{T1} is a monocyclic aromatic hydrocarbon ring or a monocyclic hetero ring containing a group represented by =N- in the ring and these rings optionally have a single or a plurality of substituents, and the above-described Ring R^{T2} is a monocyclic hetero ring containing a group represented by =N- in the ring and the ring optionally has a single or a plurality of substituents.
[10] The light emitting device according to [9], wherein the above-described Ring R^{T1} is a benzene ring, a pyridine ring or a diazabenzene ring and these rings optionally have a single or a plurality of substituents, and the above-described Ring R^{T2} is a pyridine ring or a diazabenzene ring and these rings optionally have a single or a plurality of substituents.
[11] The light emitting device according to any one of [1] to [10], wherein the above-described light emitting device further has a third layer disposed between the above-described anode and the above-described cathode, and
   the above-described third layer is a layer containing a metal complex represented by the formula (1): 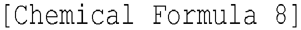 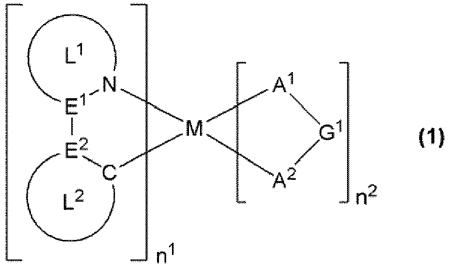 [wherein,
   M represents a rhodium atom, a palladium atom, an iridium atom or a platinum atom.
   n¹ represents an integer of 1 or more, n² represents an integer of 0 or more. n¹+n² is 3 when M is a rhodium atom or an iridium atom, while n¹+n² is 2 when M is a palladium atom or a platinum atom.
   E¹ and E² each independently represent a carbon atom or a nitrogen atom. When a plurality of E¹ and E² are present, they may be the same or different at each occurrence.
   Ring L¹ represents an aromatic hetero ring, and this ring optionally has a single or a plurality of substituents. When a plurality of the substituents are present, they may be the same or different and may be combined together to form a ring together with atoms to which they are attached. When a plurality of Ring L¹ are present, they may be the same or different.
   Ring L² represents an aromatic hydrocarbon ring or an aromatic hetero ring, and these rings optionally have a single or a plurality of substituents. When a plurality of the substituents are present, they may be the same or different and may be combined together to form a ring together with atoms to which they are attached. When a plurality of Ring L² are present, they may be the same or different.

   The substituent which Ring L¹ optionally has and the substituent which Ring L² optionally has may be the same or different and may be combined together to form a ring together with atoms to which they are attached.
   A¹-G¹-A² represents an anionic bidentate ligand. A¹ and A² each independently represent a carbon atom, an oxygen atom or a nitrogen atom, and these atoms may be ring constituent atoms. G¹ represents a single bond, or an atomic group constituting a bidentate ligand together with A¹ and A². When a plurality of A¹-G¹-A² are present, they may be the same or different.].
[12] The light emitting device according to [11], wherein the above-described Ring L¹ is a pyridine ring, a diazabenzene ring, an azanaphthalene ring, a diazanaphthalene ring, a diazole ring or a triazole ring and these rings optionally have a single or a plurality of substituents, and the above-described Ring L² is a benzene ring, a pyridine ring or a diazabenzene ring and these rings optionally have a single or a plurality of substituents.
[13] The light emitting device according to [11] or [12], wherein the above-described third layer further contains a compound represented by the formula (H-1): 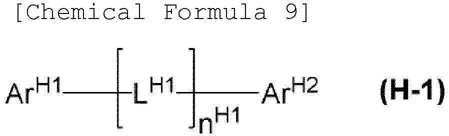 [wherein,
   Ar^{H1} and Ar^{H2} each independently represent an aryl group, a monovalent hetero ring group or a substituted amino group, and these groups optionally have a single or a plurality of substituents. When a plurality of the above-described substituents are present, they may be the same or different and may be combined together to form a ring together with atoms to which they are attached.
   n^{H1} represents an integer of 0 or more.
   L^{H1} represents an arylene group, a divalent hetero ring group, an alkylene group or a cycloalkylene group, and these groups optionally have a single or a plurality of substituents. When a plurality of the above-described substituents are present, they may be the same or different and may be combined together to form a ring together with atoms to which they are attached. When a plurality of L^{H1} are present, they may be the same or different.].
[14] The light emitting device according to any one of [11] to [13], wherein the above-described third layer is a layer disposed between the above-described second layer and the above-described first layer.
[15] The light emitting device according to [14], wherein the above-described third layer and the above-described first layer are adjacent, and the above-described third layer and the above-described second layer are adjacent.

### Effect of the Invention

According to the present invention, a light emitting device excellent in light emission efficiency can be provided.

### Brief Explanation of Drawing

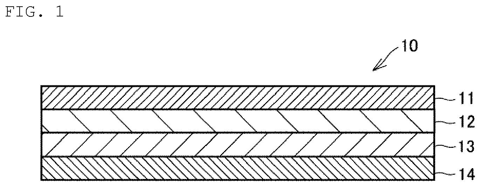

FIG. 1 is a schematic cross-sectional view of a light emitting device according to one embodiment of the present invention

### Modes for Carrying Out the Invention

Preferred embodiments of the present embodiment will be illustrated in detail below.

### <Explanation of common terms>

The terms commonly used in the present specification have the following meanings, unless otherwise stated.

### "Room temperature" means 25°C.

Me represents a methyl group, Et represents an ethyl group, Bu represents a butyl group, i-Pr represents an isopropyl group, and t-Bu represents a tert-butyl group.

The hydrogen atom may be a heavy hydrogen atom or a light hydrogen atom.

In the formula representing a metal complex, the solid line representing a bond with a central metal means a covalent bond or a coordination bond.

"The polymer compound" means a polymer having molecular weight distribution and having a polystyrene-equivalent number-average molecular weight of 1×10³ to 1×10⁸.

"The low-molecular compound" means a compound having no molecular weight distribution and having a molecular weight of 1×10⁴ or less.

"The constitutional unit" means a unit occurring once or more times in a polymer compound. Two or more constitutional units present in a polymer compound are generally referred to as "repeating unit" in some cases.

"The alkyl group" may be any of linear and branched. The number of carbon atoms of the linear alkyl group, not including the number of carbon atoms of the substituent, is usually 1 to 50, preferably 1 to 20, and more preferably 1 to 10. The number of carbon atoms of the branched alkyl group, not including the number of carbon atoms of the substituent, is usually 3 to 50, preferably 3 to 20, and more preferably 4 to 10. The alkyl group optionally has a substituent, and examples thereof include a methyl group, an ethyl group, an isopropyl group, a butyl group, an isobutyl group, a tert-butyl group, a pentyl group, a hexyl group, a heptyl group, an octyl group, a 2-ethylhexyl group, a decyl group, a 3,7-dimethyloctyl group, a 2-ethyloctyl group, a dodecyl group, a trifluoromethyl group, a 3-phenylpropyl group, a 3-(4-methylphenyl)propyl group, a 3-(3,5-di-hexylphenyl)propyl group, and a 6-ethyloxyhexyl group.

The number of carbon atoms of "the cycloalkyl group", not including the number of carbon atoms of the substituent, is usually 3 to 50, and preferably 4 to 10. The cycloalkyl group optionally has a substituent, and examples thereof include a cyclohexyl group and a methylcyclohexyl group.

The number of carbon atoms of "the alkylene group", not including the number of carbon atoms of the substituent, is usually 1 or more and 20 or less, preferably 1 or more and 15 or less, and more preferably 1 or more and 10 or less. The alkylene group optionally has a substituent, and examples thereof include a methylene group, an ethylene group, a propylene group, a butylene group, a hexylene group and an octylene group.

The number of carbon atoms of "the cycloalkylene group", not including the number of carbon atoms of the substituent, is usually 3 or more and 20 or less. The cycloalkylene group optionally has a substituent, and examples thereof include a cyclohexylene group.

"The aromatic hydrocarbon group" means a group obtained by removing from an aromatic hydrocarbon one or more hydrogen atoms bonding directly to carbon atoms constituting the ring. The group obtained by removing from an aromatic hydrocarbon one hydrogen atom bonding directly to a carbon atom constituting the ring is referred to also as "aryl group". The group obtained by removing from an aromatic hydrocarbon two hydrogen atoms bonding directly to carbon atoms constituting the ring is referred to also as "arylene group".

The number of carbon atoms of the aromatic hydrocarbon group, not including the number of carbon atoms of the substituent, is usually 6 to 60, preferably 6 to 30, and more preferably 6 to 18.

"The aromatic hydrocarbon group" includes, for example, groups obtained by removing from a monocyclic aromatic hydrocarbon (including, for example, benzene) or a polycyclic aromatic hydrocarbon (including, for example, 2-cyclic aromatic hydrocarbons such as naphthalene and indene and the like; 3-cyclic aromatic hydrocarbons such as anthracene, phenanthrene, dihydrophenanthrene and fluorene and the like; 4-cyclic aromatic hydrocarbons such as triphenylene, naphthacene, benzofluorene, pyrene, chrysene and fluoranthene and the like; 5-cyclic aromatic hydrocarbons such as dibenzofluorene, perylene and benzofluoranthene and the like; 6-cyclic aromatic hydrocarbons such as spirobifluorene and the like; and 7-cyclic aromatic hydrocarbons such as benzospirobifluorene and acenaphthofluoranthene and the like) one or more hydrogen atoms bonding directly to carbon atoms constituting the ring, and these groups optionally have a substituent. The aromatic hydrocarbon group includes groups in which a plurality of these groups are bonded.

"The alkoxy group" may be any of linear and branched. The number of carbon atoms of the linear alkoxy group, not including the number of carbon atoms of the substituent, is usually 1 to 40, and preferably 1 to 10. The number of carbon atoms of the branched alkoxy group, not including the number of carbon atoms of the substituent, is usually 3 to 40, and preferably 4 to 10. The alkoxy group optionally has a substituent, and examples thereof include a methoxy, an ethoxy, an isopropyloxy group, a butyloxy group, a hexyloxy group, a 2-ethylhexyloxy group, a 3,7-dimethyloctyloxy group, and a lauryloxy group.

The number of carbon atoms of "the cycloalkoxy group", not including the number of carbon atoms of the substituent, is usually 3 to 40, and preferably 4 to 10. The cycloalkoxy group optionally has a substituent, and examples thereof include a cyclohexyloxy group.

The number of carbon atoms of "the aryloxy group", not including the number of carbon atoms of the substituent, is usually 6 to 60, and preferably 6 to 48. The aryloxy group optionally has a substituent, and examples thereof include a phenoxy group, a naphthyloxy group, an anthracenyloxy group, and a pyrenyloxy group.

"The hetero ring group" means a group obtained by removing from a heterocyclic compound one or more hydrogen atoms bonding directly to carbon atoms or hetero atoms constituting the ring. Of hetero ring groups, "aromatic hetero ring group" which is a group obtained by removing from an aromatic heterocyclic compound one or more hydrogen atoms bonding directly to carbon atoms or hetero atoms constituting the ring is preferable. A group obtained by removing from a heterocyclic compound p hydrogen atoms (p represents an integer of 1 or more) bonding directly to carbon atoms or hetero atoms constituting the ring is referred to also as "p-valent hetero ring group". A group obtained by removing from an aromatic heterocyclic compound p hydrogen atoms bonding directly to carbon atoms or hetero atoms constituting the ring is referred to also as "p-valent aromatic hetero ring group".

"The aromatic heterocyclic compound" includes, for example, compounds of which hetero ring itself shows aromaticity such as azole, thiophene, furan, pyridine, diazabenzene, triazine, azanaphthalene, diazanaphthalene and carbazole and the like, and compounds in which an aromatic ring is condensed to the hetero ring though the hetero ring itself shows no aromaticity such as phenoxazine, phenothiazine and benzopyran and the like.

The number of carbon atoms of the hetero ring group, not including the number of carbon atoms of the substituent, is usually 1 to 60, preferably 2 to 40, and more preferably 3 to 20. The number of hetero atoms of the hetero ring group, not including the number of carbon atoms of the substituent, is usually 1 to 30, preferably, 1 to 10, and more preferably 1 to 3.

The hetero ring group optionally has a substituent, and examples thereof include groups obtained by removing from a monocyclic heterocyclic compound (including, for example, furan, thiophene, oxadiazole, pyrrole, diazole, triazole, tetrazole, pyridine, diazabenzene and triazine) or a polycyclic heterocyclic compound (including, for example, 2-cyclic heterocyclic compounds such as azanaphthalene, diazanaphthalene, benzofuran, benzothiophene, indole, benzodiazole and benzothiadiazole and the like; 3-cyclic heterocyclic compounds such as dibenzofuran, dibenzothiophene, carbazole, azacarbazole, diazacarbazole, phenoxazine, phenothiazine, 9,10-dihydroacridine, 5,10-dihydrophenazine, azaanthracene, diazaanthracene, azaphenanthrene and diazaphenanthrene and the like; 4-cyclic heterocyclic compounds such as hexaazatriphenylene, benzocarbazole and benzonaphthofuran and the like; 5-cyclic heterocyclic compounds such as dibenzocarbazole, indolocarbazole and indenocarbazole and the like; 6-cyclic heterocyclic compounds such as carbazolocarbazole, benzoindolocarbazole and benzoindenocarbazole and the like; and 7-cyclic heterocyclic compounds such as dibenzoindolocarbazole and the like) one or more hydrogen atoms bonding directly to atoms constituting the ring, and these groups optionally have a substituent. The hetero ring group includes groups in which a plurality of these groups are bonded.

"The halogen atom" denotes a fluorine atom, a chlorine atom, a bromine atom or an iodine atom.

"The amino group" optionally has a substituent, with a substituted amino group being preferred. The substituent which an amino group has is preferably an alkyl group, a cycloalkyl group, an aryl group or a monovalent hetero ring group.

The substituted amino group includes, for example, a dialkylamino group, a dicycloalkylamino group and a diarylamino group.

The amino group includes, for example, a dimethylamino group, a diethylamino group, a diphenylamino group, a bis(methylphenyl)amino group and a bis(3,5-di-tert-butylphenyl)amino group.

"The alkenyl group" may be any of linear and branched. The number of carbon atoms of the linear alkenyl group, not including the number of carbon atoms of the substituent, is usually 2 to 30, and preferably 3 to 20. The number of carbon atoms of the branched alkenyl group, not including the number of carbon atoms of the substituent, is usually 3 to 30, and preferably 4 to 20.

The number of carbon atoms of "the cycloalkenyl group", not including the number of carbon atoms of the substituent, is usually 3 to 30, and preferably 4 to 20.

The alkenyl group and the cycloalkenyl group optionally have a substituent, and examples thereof include a vinyl group, a propenyl group, a butenyl group, a 3-butenyl group, a 3-pentenyl group, a 4-pentenyl group, a 1-hexenyl group, a 5-hexenyl group, a 7-octenyl group, and these groups having a substituent.

"The alkynyl group" may be any of linear and branched. The number of carbon atoms of the alkynyl group, not including carbon atoms of the substituent, is usually 2 to 20, and preferably 3 to 20. The number of carbon atoms of the branched alkynyl group, not including carbon atoms of the substituent, is usually 4 to 30, and preferably 4 to 20.

The number of carbon atoms of "the cycloalkynyl group", not including carbon atoms of the substituent, is usually 4 to 30, and preferably 4 to 20.

More specifically, the substituted alkynyl group and the cycloalkynyl group optionally have a substituent, and examples thereof include an ethynyl group, a propynyl group, a butynyl group, a pentynyl group, a hexynyl group, a 5-hexynyl group, and these groups having a substituent.

"The crosslinkable group" is a group which is capable of generating a new bond by being substituted to heating, ultraviolet irradiation, near ultraviolet irradiation, visible light irradiation, infrared irradiation, radical reaction and the like, and is preferably a crosslinkable group selected from Group A of crosslinkable group (namely, a group represented by any of the formula (XL-1) to the formula (XL-17)).

"The substituent" includes, for example, a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group and a cycloalkynyl group. The substituent may be a crosslinkable group. The substituent-carrying group can have a single or a plurality of substituents. When a plurality of substituents are present, they may be the same or different and they may be combined together to form a ring together with atoms to which they are attached, but it is preferable that they do not form a ring.

### <Metal complex represented by the formula (1)>

The metal complex represented by the formula (1) is usually a metal complex showing phosphorescence at room temperature, and preferably a metal complex showing light emission from triplet excited state at room temperature.

M is preferably an iridium atom or a platinum atom, and more preferably an iridium atom, since the light emitting device of the present embodiment is more excellent in light emission efficiency.

When M is a rhodium atom or an iridium atom, n³ is preferably 2 or 3, and more preferably 3.

When M is a palladium atom or a platinum atom, n³ is preferably 2.

It is preferable that at least one of E¹ and E² is a carbon atom, and it is more preferable that E¹ and E² each represent a carbon atom.

It is preferable that E¹ and E² are the same, since a metal complex represented by the formula (1) can be synthesized easily. When a plurality of E¹ are present, it is preferable that they are the same, since a metal complex represented by the formula (1) can be synthesized easily. When a plurality of E² are present, it is preferable that they are the same, since a metal complex represented by the formula (1) can be synthesized easily.

The number of carbon atoms of the aromatic hetero ring represented by Ring L¹, not including the number of carbon atoms of the substituent, is usually 1 to 60, preferably 2 to 30, and more preferably 2 to 15. The number of hetero atoms of the aromatic hetero ring represented by Ring L¹, not including the number of carbon atoms of the substituent, is usually 1 to 10, preferably 1 to 5, and more preferably 1 to 3.

Ring L¹ is preferably a 5-membered aromatic hetero ring or a 6-membered aromatic hetero ring, and more preferably a 5-membered aromatic hetero ring having 2 or more and 4 or less nitrogen atoms as constituent atoms or a 6-membered aromatic hetero ring having 1 or more and 4 or less nitrogen atoms as constituent atoms, and these rings optionally have a substituent. When Ring L¹ is a 6-membered aromatic hetero ring, E¹ is preferably a carbon atom.

Ring L¹ is preferably a pyridine ring, a diazabenzene ring, an azanaphthalene ring, a diazanaphthalene ring, a triazole ring or a diazole ring, more preferably a pyridine ring, a quinoline ring, an isoquinoline ring, a triazole ring or a diazole ring, further preferably a triazole ring or a diazole ring, and particularly preferably a diazole ring, and these rings optionally have a substituent, since the light emitting device of the present embodiment is more excellent in light emission efficiency.

When a plurality of Ring L¹ are present, it is preferable that they are the same, since a metal complex represented by the formula (1) can be synthesized easily.

The number of carbon atoms of the aromatic hydrocarbon ring represented by Ring L², not including the number of carbon atoms of the substituent, is usually 6 to 60, preferably 6 to 30, and further preferably 6 to 18.

The aromatic hydrocarbon ring represented by Ring L² includes, for example, aromatic hydrocarbon rings exemplified in the section of the aromatic hydrocarbon group described above, preferably, rings composed of a monocyclic, 2-cyclic or 3-cyclic aromatic hydrocarbon exemplified in the section of the aromatic hydrocarbon group described above, more preferably, a benzene ring, a naphthalene ring, a fluorene ring, a phenanthrene ring or a dihydrophenanthrene ring, further preferably, a benzene ring, a fluorene ring or a dihydrophenanthrene ring, and particularly preferably, a benzene ring, and these rings optionally have a substituent.

The number of carbon atoms of the aromatic hetero ring represented by Ring L², not including the number of carbon atoms of the substituent, is usually 1 to 60, preferably 2 to 30, and more preferably 3 to 15. The number of hetero atoms of the aromatic hetero ring represented by Ring L², not including the number of carbon atoms of the substituent, is usually 1 to 30, preferably, 1 to 10, and more preferably 1 to 3.

The aromatic hetero ring represented by Ring L² includes, for example, aromatic hetero rings exemplified in the section of the hetero ring group described above, preferably, monocyclic, 2-cyclic or 3-cyclic aromatic hetero rings exemplified in the section of the hetero ring group described above, more preferably, a pyridine ring, a diazabenzene ring, an azanaphthalene ring, a diazanaphthalene ring, an indole ring, a benzofuran ring, a benzothiophene ring, a carbazole ring, an azacarbazole ring, a diazacarbazole ring, a dibenzofuran ring or a dibenzothiophene ring, further preferably, a pyridine ring, a diazabenzene ring, a carbazole ring, a dibenzofuran ring or a dibenzothiophene ring, and particularly preferably, a pyridine ring or a diazabenzene ring, and these rings optionally have a substituent.

Ring L² is preferably a benzene ring, a pyridine ring or a diazabenzene ring, and more preferably a benzene ring, and these rings optionally have a substituent, since the light emitting device of the present embodiment is more excellent in light emission efficiency.

When a plurality of Ring L² are present, it is preferable that they are the same, since a metal complex represented by the formula (1) can be synthesized easily.

It is preferable that Ring L¹ is a pyridine ring, a diazabenzene ring, an azanaphthalene ring, a diazanaphthalene ring, a triazole ring or a diazole ring and Ring L² is a benzene ring, a pyridine ring or a diazabenzene ring, it is more preferable that Ring L¹ is a pyridine ring, a quinoline ring, an isoquinoline ring, a triazole ring or a diazole ring and Ring L² is a benzene ring, it is further preferable that Ring L¹ is a triazole ring or a diazole ring and Ring L² is a benzene ring, and it is particularly preferable that Ring L¹ is a diazole ring and Ring L² is a benzene ring, and these rings optionally have a substituent, since the light emitting device of the present embodiment is more excellent in light emission efficiency.

The substituent which Ring L¹ and Ring L² optionally have is preferably an alkyl group, a cycloalkyl group, an alkoxy group, a cycloalkoxy group, an aryl group, an aryloxy group, a monovalent hetero ring group, a substituted amino group or a fluorine atom, more preferably an alkyl group, a cycloalkyl group, an aryl group, a monovalent hetero ring group or a substituted amino group, further preferably an alkyl group, a cycloalkyl group, an aryl group or a monovalent hetero ring group, and particularly preferably an aryl group, and these groups optionally further have a substituent.

It is preferable that at least one of Ring L¹ and Ring L² has a substituent, since the light emitting device of the present embodiment is more excellent in light emission efficiency. The number of the substituent which at least one of Ring L¹ and Ring L² has is usually 1 to 5, and it is preferably 1 to 3, more preferably 1 or 2, and further preferably 1, since a metal complex represented by the formula (1) can be synthesized easily.

The aryl group as the substituent which Ring L¹ and Ring L² optionally have is preferably a group obtained by removing from a monocyclic, 2-cyclic or 3-cyclic aromatic hydrocarbon one hydrogen atom bonding directly to a carbon atom constituting the ring, more preferably a phenyl group, a naphthyl group or a fluorenyl group, and further preferably a phenyl group, and these groups optionally have a substituent.

The monovalent hetero ring group as the substituent which Ring L¹ and Ring L² optionally have is preferably a group obtained by removing from a monocyclic, 2-cyclic or 3-cyclic heterocyclic compound one hydrogen atom bonding directly to a carbon atom or a hetero atom constituting the ring, more preferably a group obtained by removing from a pyridine ring, a diazabenzene ring, a triazine ring, an azanaphthalene ring, a diazanaphthalene ring, a carbazole ring, a dibenzofuran ring or a dibenzothiophene ring one hydrogen atom bonding directly to a carbon atom or a hetero atom constituting the ring, and further preferably a group obtained by removing from a pyridine ring, a diazabenzene ring or a triazine ring one hydrogen atom bonding directly to a carbon atom constituting the ring, and these groups optionally have a substituent.

In the substituted amino group as the substituent which Ring L¹ and Ring L² optionally have, the substituent which an amino group has is preferably an aryl group or a monovalent hetero ring group, and more preferably an aryl group, and these groups optionally further have a substituent. The examples and preferable ranges of the aryl group and the monovalent hetero ring group as the substituent which an amino group has are the same as the examples and preferable ranges of the aryl group and the monovalent hetero ring group as the substituent which Ring L¹ and Ring L² optionally have, respectively.

The substituent which the substituent which Ring L¹ and Ring L² optionally have optionally further has is preferably an alkyl group, a cycloalkyl group, an aryl group, a monovalent hetero ring group or a substituted amino group, further preferably an alkyl group, a cycloalkyl group or an aryl group, and particularly preferably an alkyl group or a cycloalkyl group, and these groups optionally further have a substituent, however, it is preferable that they do not further have a substituent, since a metal complex represented by the formula (1) can be synthesized easily.

The examples and preferable ranges of the aryl group, the monovalent hetero ring group and the substituted amino group as the substituent which the substituent which Ring L¹ and Ring L² optionally have optionally further has are the same as the examples and preferable ranges of the aryl group, the monovalent hetero ring group and the substituted amino group as the substituent which Ring L¹ and Ring L² optionally have, respectively.

### [Anionic bidentate ligand]

The anionic bidentate ligand represented by A¹-G¹-A² includes, for example, ligands represented by the following formulae. However, the anionic bidentate ligand represented by A¹-G¹-A² is different from a ligand of which number is defined by the subscript n¹. 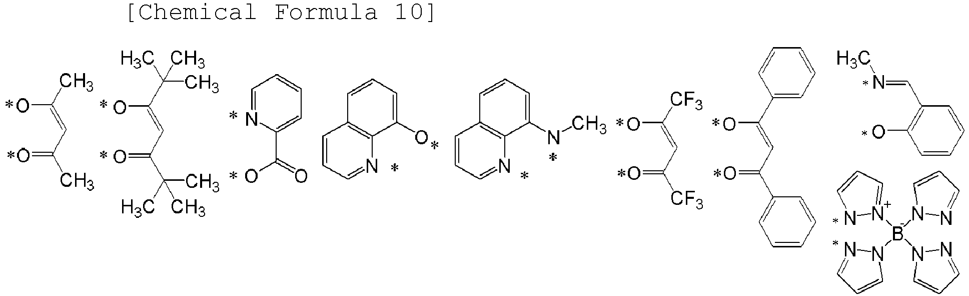 [wherein, * represents a site binding to M.]

The metal complex represented by the formula (1) includes, for example, metal complexes represented by the following formulae and metal complexes B1 and R1 described later. In the formulae, Z^{A} represents a group represented by -CH= or a group represented by -N=. When a plurality of Z^{A} are present, they may be the same or different.

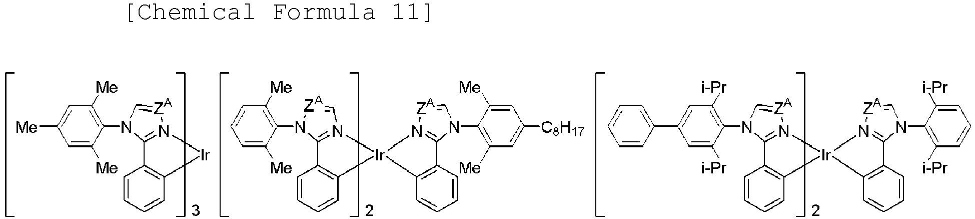

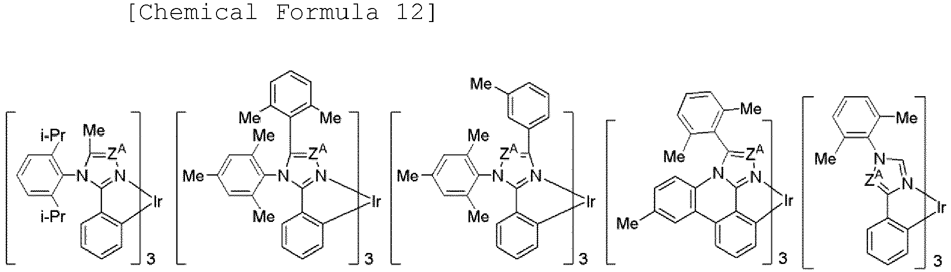

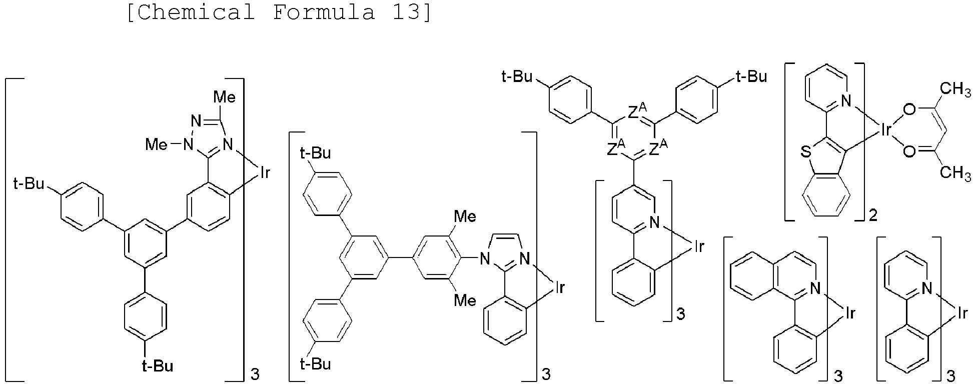

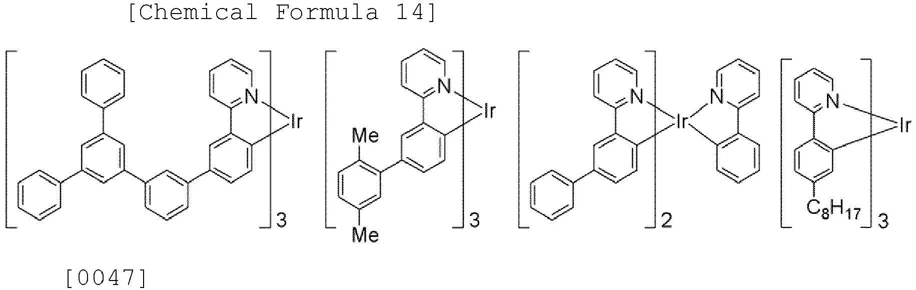

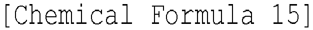

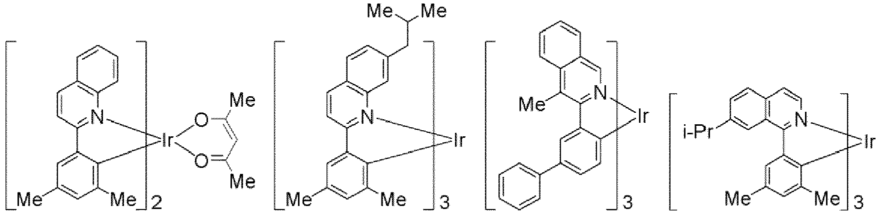

### <Compound represented by the formula (H-1)>

The molecular weight of the compound represented by the formula (H-1) is usually 1×10² to 1×10⁴, preferably 2×10² to 5×10³, more preferably 3×10² to 3×10³, and further preferably 4×10² to 1×10³.

The aryl group represented by Ar^{H1} and Ar^{H2} and the arylene group represented by L^{H1} are preferably a group obtained by removing from a monocyclic or 2 to 6-cyclic aromatic hydrocarbon one or two hydrogen atoms bonding directly to carbon atoms constituting the ring (in the case of the aryl group, one hydrogen atom, and in the case of the arylene group, two hydrogen atoms, the same shall apply hereinafter), more preferably a group obtained by removing from a monocyclic or 2 to 4-cyclic aromatic hydrocarbon one or two hydrogen atoms bonding directly to carbon atoms constituting the ring, and further preferably a group obtained by removing from benzene, naphthalene, fluorene, phenanthrene or triphenylene one or two hydrogen atoms bonding directly to carbon atoms constituting the ring, and these groups optionally have a substituent.

The monovalent hetero ring group represented by Ar^{H1} and Ar^{H2} and the divalent hetero ring group represented by L^{H1} are preferably a group obtained by removing from a monocyclic or 2 to 6-cyclic heterocyclic compound one or two hydrogen atoms bonding directly to carbon atoms or hetero atoms constituting the ring (in the case of the monovalent hetero ring group, one hydrogen atom, and in the case of the divalent hetero ring group, two hydrogen atoms, the same shall apply hereinafter), more preferably a group obtained by removing from a monocyclic, 2-cyclic, 3-cyclic or 5-cyclic heterocyclic compound one or two hydrogen atoms bonding directly to carbon atoms or hetero atoms constituting the ring, further preferably a group obtained by removing from pyridine, diazabenzene, triazine, azanaphthalene, diazanaphthalene, carbazole, dibenzofuran, dibenzothiophene, phenoxazine, phenothiazine, dibenzocarbazole, indolocarbazole or indenocarbazole one or two hydrogen atoms bonding directly to carbon atoms or hetero atoms constituting the ring, and particularly preferably a group obtained by removing from pyridine, diazabenzene, triazine, azanaphthalene, diazanaphthalene, carbazole, dibenzofuran or dibenzothiophene one or two hydrogen atoms bonding directly to carbon atoms or hetero atoms constituting the ring, and these groups optionally have a substituent.

In the substituted amino group represented by Ar^{H1} and Ar^{H2}, the substituent which an amino group has is preferably an aryl group or a monovalent hetero ring group, and more preferably an aryl group, and these groups optionally further have a substituent. The examples and preferable ranges of the aryl group as the substituent which an amino group has are the same as the examples and preferable ranges of the aryl group represented by Ar^{H1} and Ar^{H2}. The examples and preferable ranges of the monovalent hetero ring group as the substituent which an amino group has are the same as the examples and preferable ranges of the monovalent hetero ring group represented by Ar^{H1} and Ar^{H2} .

At least one of Ar^{H1} and Ar^{H2} is preferably an aryl group or a monovalent hetero ring group, more preferably a monovalent hetero ring group, further preferably a carbazolyl group, a dibenzothienyl group or a dibenzofuryl group, and particularly preferably a carbazolyl group, and these groups optionally have a substituent, since the light emitting device of the present embodiment is more excellent in light emission efficiency.

Ar^{H1} and Ar^{H2} are each preferably an aryl group or a monovalent hetero ring group, more preferably a group obtained by removing from benzene, fluorene, pyridine, diazabenzene, triazine, carbazole, dibenzofuran or dibenzothiophene one hydrogen atom bonding directly to a carbon atom or a hetero atom constituting the ring, further preferably a phenyl group, a fluorenyl group, a dibenzothienyl group, a dibenzofuryl group or a carbazolyl group, and particularly preferably a carbazolyl group, and these groups optionally have a substituent, since the light emitting device of the present embodiment is further excellent in light emission efficiency.

At least one L^{H1} is preferably an arylene group or a divalent hetero ring group, more preferably a divalent hetero ring group, and further preferably a group obtained by removing from carbazole, dibenzofuran or dibenzothiophene two hydrogen atoms bonding directly to carbon atoms or hetero atoms (preferably carbon atoms) constituting the ring, and these groups optionally further have a substituent, since the light emitting device of the present embodiment is more excellent in light emission efficiency.

L^{H1} is preferably an arylene group or a divalent hetero ring group, more preferably a group obtained by removing from benzene, naphthalene, fluorene, pyridine, diazabenzene, triazine, azanaphthalene, diazanaphthalene, carbazole, dibenzofuran or dibenzothiophene two hydrogen atoms bonding directly to carbon atoms or hetero atoms constituting the ring, further preferably a group obtained by removing from benzene, fluorene, pyridine, diazabenzene, triazine, carbazole, dibenzofuran or dibenzothiophene two hydrogen atoms bonding directly to carbon atoms or hetero atoms constituting the ring, and particularly preferably a group obtained by removing from dibenzofuran or dibenzothiophene two hydrogen atoms bonding directly to carbon atoms constituting the ring, and these groups optionally have a substituent, since the light emitting device of the present embodiment is further excellent in light emission efficiency.

The substituent which Ar^{H1}, Ar^{H2} and L^{H1} optionally have is preferably an alkyl group, a cycloalkyl group, an alkoxy group, a cycloalkoxy group, an aryl group, a monovalent hetero ring group, a substituted amino group or a fluorine atom, more preferably an alkyl group, a cycloalkyl group, an aryl group, a monovalent hetero ring group or a substituted amino group, and further preferably an alkyl group, an aryl group or a monovalent hetero ring group, and these groups optionally further have a substituent.

The examples and preferable ranges of the aryl group, the monovalent hetero ring group and the substituted amino group as the substituent which Ar^{H1}, Ar^{H2} and L^{H1} optionally have are the same as the examples and preferable ranges of the aryl group, the monovalent hetero ring group and the substituted amino group represented by Ar^{H1} and Ar^{H2}, respectively.

The substituent which the substituent which Ar^{H1}, Ar^{H2} and L^{H1} optionally have optionally further has is preferably an alkyl group, a cycloalkyl group, an aryl group, a monovalent hetero ring group or a substituted amino group, and more preferably an alkyl group or a cycloalkyl group, and these groups optionally further have a substituent, however, it is preferable that they do not further have a substituent.

The examples and preferable ranges of the aryl group, the monovalent hetero ring group and the substituted amino group as the substituent which the substituent which Ar^{H1}, Ar^{H2} and L^{H1} optionally have optionally further has are the same as the examples and preferable ranges of the aryl group, the monovalent hetero ring group and the substituted amino group represented by Ar^{H1} and Ar^{H2}, respectively.

n^{H1} is usually an integer of 0 or more and 10 or less, preferably an integer of 0 or more and 5 or less, further preferably an integer of 1 or more and 3 or less, and particularly preferably 1.

The compound represented by the formula (H-1) includes, for example, compounds represented by the following formulae. In the formulae, Z^{A} represent the same meaning as described above. In the formulae, Z^{B} represents an oxygen atom or a sulfur atom. When a plurality of Z^{B} are present, they may be the same or different.

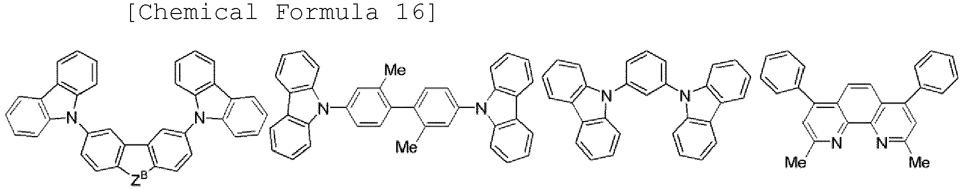

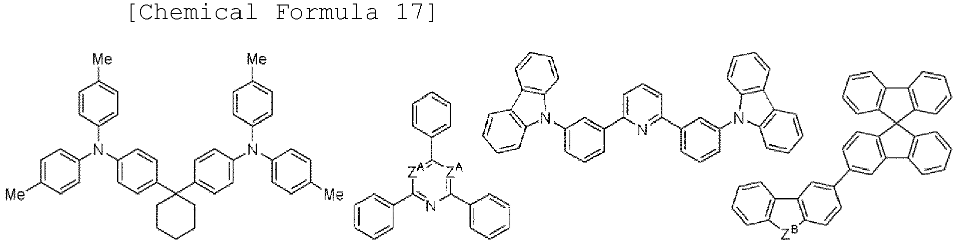

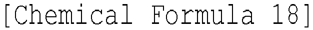

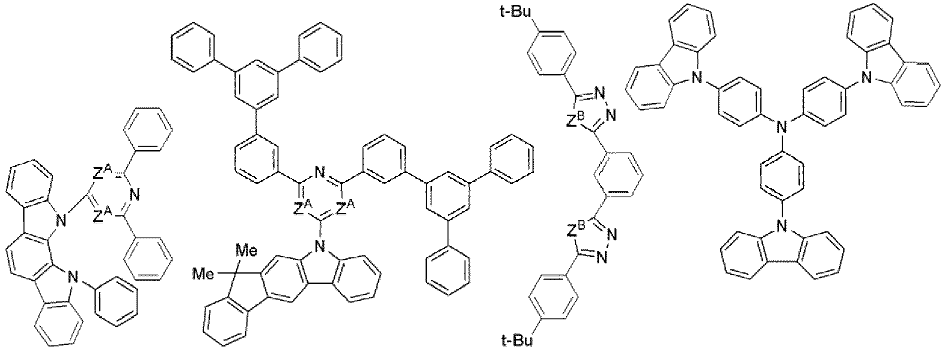

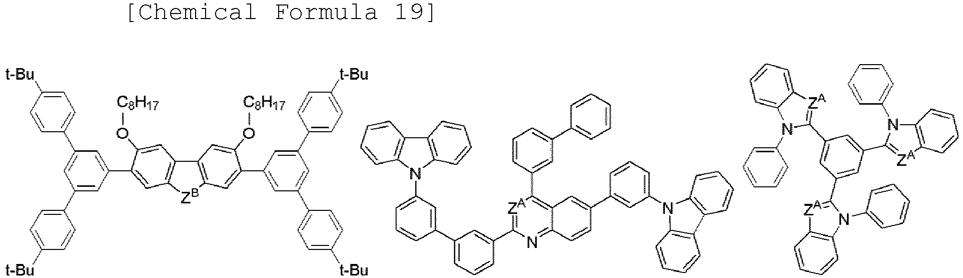

### <Compound represented by the formula (T-1)>

The molecular weight of the compound represented by the formula (T-1) is usually 1×10² to 1×10⁴, preferably 2×10² to 5×10³, more preferably 3×10² to 3×10³, and further preferably 4×10² to 1.5×10³.

n^{T1} is preferably an integer of 0 or more and 3 or less, and more preferably 0 or 1, since the light emitting device of the present embodiment is more excellent in light emission efficiency.

n^{T2} is preferably an integer of 1 or more and 5 or less, more preferably an integer of 1 or more and 3 or less, and further preferably 2, since the light emitting device of the present embodiment is more excellent in light emission efficiency.

"The nitrogen atom having no double bond" means a nitrogen atom having only a single bond between a nitrogen atom and all atoms bonding to the nitrogen atom.

"Containing a nitrogen atom having no double bond in the ring" means to contain -N(-R^{N})- (wherein, R^{N} represents a hydrogen atom or a substituent.) or a group represented by the formula: 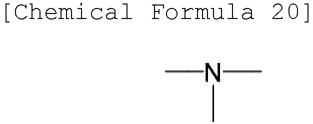 in the ring.

In the condensed monovalent hetero ring group containing a nitrogen atom having no double bond and a group represented by =N- in the ring (hereinafter, referred to also as "hetero ring group represented by Ar^{T1}"), the number of the nitrogen atom having no double bond constituting the ring is usually 1 to 10, preferably 1 to 5, more preferably 1 to 3, and further preferably 1 or 2. Further, in the condensed monovalent hetero ring group, the number of the group represented by =N- constituting the ring is usually 1 to 10, preferably 1 to 5, more preferably 1 to 3, and further preferably 1 or 2. In the condensed monovalent hetero ring group, the number of carbon atoms constituting the ring is usually 2 to 60, preferably 5 to 30, and more preferably 8 to 25.

The hetero ring group represented by Ar^{T1} is preferably a group obtained by removing from a heterocyclic compound in which 1 or more (preferably 5 or less, more preferably 3 or less, further preferably 1) hetero rings containing a nitrogen atom having no double bond in the ring and containing no group represented by =N- in the ring (hereinafter, referred to also as "donor type hetero ring") and 1 or more (preferably 5 or less, more preferably 3 or less, further preferably 1) hetero rings containing a group represented by =N- in the ring are condensed one hydrogen atom bonding directly to a carbon atom or a hetero atom constituting the ring, and these groups optionally have a substituent.

In the donor type hetero ring, the number of carbon atoms constituting the ring is usually 1 to 60, preferably 2 to 30, and more preferably 3 to 15. In the donor type hetero ring, the number of the nitrogen atom having no double bond constituting the ring is usually 1 to 10, preferably 1 to 5, more preferably 1 to 3, and further preferably 1 or 2.

The donor type hetero ring includes, for example, hetero rings containing a nitrogen atom having no double bond in the ring and containing no group represented by =N-in the ring in the heterocyclic compounds exemplified in the section of the hetero ring group described above, and of them, preferable are monocyclic or 2 to 5-cyclic hetero rings, more preferable are monocyclic, 2-cyclic or 3-cyclic hetero rings, and further preferable are monocyclic or 2-cyclic hetero rings, and these rings optionally have a substituent.

The donor type hetero ring is preferably a pyrrole ring, an indole ring, a carbazole ring, a 9,10-dihydroacridine ring, a 5,10-dihydrophenazine ring, a phenoxazine ring or a phenothiazine ring, more preferably a pyrrole ring, an indole ring or a carbazole ring, and further preferably a pyrrole ring or an indole ring, and these rings optionally have a substituent, since the light emitting device of the present embodiment is more excellent in light emission efficiency.

The examples and preferable ranges of the substituent which the donor type hetero ring optionally has are the same as the examples and preferable ranges of the substituent which Ar^{H1}, Ar^{H2} and L^{H1} optionally have.

In the hetero ring containing a group represented by =N- in the ring, the number of carbon atoms constituting the ring is usually 1 to 60, preferably 2 to 30, and more preferably 3 to 15. In the hetero ring containing a group represented by =N- in the ring, the number of the group represented by =N- constituting the ring is usually 1 to 10, preferably 1 to 5, more preferably 1 to 3, and further preferably 1 or 2.

The hetero ring containing a group represented by =N-in the ring includes, for example, hetero rings containing a group represented by =N- in the ring in the heterocyclic compounds exemplified in the section of the hetero ring group described above, and of them, preferable are monocyclic, 2-cyclic or 3-cyclic hetero rings, and more preferable are monocyclic hetero rings, and these rings optionally have a substituent.

The hetero ring containing a group represented by =N-in the ring is preferably a diazole ring, a triazole ring, a tetrazole ring, a pyridine ring, a diazabenzene ring, a triazine ring, an azanaphthalene ring, a diazanaphthalene ring, an azacarbazole ring, a diazacarbazole ring, an azaanthracene ring, a diazaanthracene ring, an azaphenanthrene ring or a diazaphenanthrene ring, more preferably a pyridine ring, a diazabenzene ring, an azanaphthalene ring, a diazanaphthalene ring, an azacarbazole or a diazacarbazole ring, and further preferably a pyridine ring or a diazabenzene ring, and these rings optionally have a substituent, since the light emitting device of the present embodiment is more excellent in light emission efficiency.

The examples and preferable ranges of the substituent which a hetero ring containing a group represented by =N-in the ring optionally has are the same as the examples and preferable ranges of the substituent which Ar^{H1}, Ar^{H2} and L^{H1} optionally have.

The hetero ring group represented by Ar^{T1} includes, for example, groups obtained by removing from azaindole, diazaindole, azacarbazole, diazacarbazole, or a heterocyclic compound in which 1 or more (preferably 5 or less, more preferably 3 or less, further preferably 1) donor type hetero rings and/or hetero rings containing a group represented by =N- in the ring are condensed to these rings one hydrogen atom bonding directly to a carbon atom or a hetero atom constituting the ring, preferably, it is a group obtained by removing from azacarbazole or diazacarbazole one hydrogen atom bonding directly to a carbon atom or a hetero atom constituting the ring, and these groups optionally have a substituent.

The examples and preferable ranges of the substituent which the hetero ring group represented by Ar^{T1} optionally has are the same as the examples and preferable ranges of the substituent which Ar^{H1}, Ar^{H2} and L^{H1} optionally have.

When a plurality of Ar^{T1} are present, it is preferable that they are the same, since a compound represented by the formula (T-1) can be synthesized easily.

The hetero ring group represented by Ar^{T1} is preferably a group represented by the formula (T1-1), since the light emitting device of the present embodiment is more excellent in light emission efficiency.

### [Group represented by the formula (T1-1)]

X^{T1} is preferably a single bond, an oxygen atom, a sulfur atom or a group represented by -C(R^{XT1'})₂-, more preferably a single bond, an oxygen atom or a sulfur atom, and further preferably a single bond.

R^{XT1} is preferably an alkyl group, a cycloalkyl group, an aryl group or a monovalent hetero ring group, more preferably an aryl group or a monovalent hetero ring group, and further preferably an aryl group, and these groups optionally have a substituent.

R^{XT1}' is preferably an alkyl group, a cycloalkyl group, an aryl group, monovalent hetero ring group or a substituted amino group, more preferably an alkyl group or an aryl group, and further preferably an alkyl group, and these groups optionally have a substituent.

It is preferable that a plurality of R^{XT1'} are not combined together to form a ring together with carbon atoms to which they are attached.

The examples and preferable ranges of the aryl group, the monovalent hetero ring group and the substituted amino group represented by R^{XT1} and R^{XT1'} are the same as the examples and preferable ranges of the aryl group, the monovalent hetero ring group and the substituted amino group represented by Ar^{H1} and Ar^{H2}, respectively.

The examples and preferable ranges of the substituent which R^{XT1} and R^{XT1'} optionally have are the same as the examples and preferable ranges of the substituent which Ar^{H1}, Ar^{H2} and L^{H1} optionally have.

The number of carbon atoms of the aromatic hydrocarbon ring represented by Ring R^{T1} and Ring R^{T2}, not including the number of carbon atoms of the substituent, is usually 6 to 60, preferably 6 to 30, and further preferably 6 to 18.

The aromatic hydrocarbon ring represented by Ring R^{T1} and Ring R^{T2} includes, for example, aromatic hydrocarbon rings exemplified in the section of the aromatic hydrocarbon group described above, preferably, monocyclic, 2-cyclic or 3-cyclic aromatic hydrocarbon rings exemplified in the section of the aromatic hydrocarbon group described above, and more preferably, monocyclic aromatic hydrocarbon rings, and these groups optionally have a substituent, since the light emitting device of the present embodiment is more excellent in light emission efficiency.

The aromatic hydrocarbon ring represented by Ring R^{T1} and Ring R^{T2} is preferably a benzene ring, a naphthalene ring, a fluorene ring, a phenanthrene ring or a dihydrophenanthrene ring, more preferably a benzene ring, a fluorene ring or a dihydrophenanthrene ring, and further preferably a benzene ring, and these rings optionally have a substituent, since the light emitting device of the present embodiment is further excellent in light emission efficiency.

The number of carbon atoms of the hetero ring represented by Ring R^{T1} and Ring R^{T2}, not including the number of carbon atoms of the substituent, is usually 1 to 60, preferably 2 to 30, and more preferably 3 to 15. The number of hetero atoms of the hetero ring represented by Ring R^{T1} and Ring R^{T2}, not including the number of carbon atoms of the substituent, is usually 1 to 30, preferably, 1 to 10, and more preferably 1 to 3.

The hetero ring represented by Ring R^{T1} and Ring R^{T2} includes, for example, hetero rings exemplified in the section of the hetero ring group described above, preferably, monocyclic, 2-cyclic or 3-cyclic hetero rings exemplified in the section of the hetero ring group described above (preferably, a donor type hetero ring or a hetero ring containing a group represented by =N- in the ring, more preferably a hetero ring containing a group represented by =N- in the ring), and more preferably, monocyclic hetero rings (preferably, a donor type hetero ring or a hetero ring containing a group represented by =N-in the ring, more preferably a hetero ring containing a group represented by =N- in the ring), and these rings optionally have a substituent, since the light emitting device of the present embodiment is more excellent in light emission efficiency.

The hetero ring represented by Ring R^{T1} and Ring R^{T2} is preferably a carbazole ring, a 9,10-dihydroacridine ring, a 5,10-dihydrophenazine ring, a phenoxazine ring, a phenothiazine ring, a pyridine ring, a diazabenzene ring, an azanaphthalene ring, a diazanaphthalene ring, an azacarbazole ring, a diazacarbazole ring, a dibenzofuran ring or a dibenzothiophene ring, more preferably a pyridine ring, a diazabenzene ring, an azanaphthalene ring, a diazanaphthalene ring, an azacarbazole or a diazacarbazole ring, and further preferably a pyridine ring or a diazabenzene ring, and these rings optionally have a substituent, since the light emitting device of the present embodiment is further excellent in light emission efficiency.

Ring R^{T1} is preferably an aromatic hydrocarbon ring or a hetero ring containing a group represented by =N- in the ring, more preferably a monocyclic aromatic hydrocarbon rings or a monocyclic hetero ring containing a group represented by =N- in the ring, further preferably a benzene ring, a pyridine ring or a diazabenzene ring, and particularly preferably a benzene ring, and these rings optionally have a substituent, since the light emitting device of the present embodiment is more excellent in light emission efficiency.

Ring R^{T2} is preferably a hetero ring containing a group represented by =N- in the ring, more preferably a monocyclic hetero ring containing a group represented by =N- in the ring, further preferably a pyridine ring or a diazabenzene ring, and particularly preferably a pyridine ring, and these rings optionally have a substituent, since the light emitting device of the present embodiment is more excellent in light emission efficiency.

It is preferable that Ring R^{T1} is an aromatic hydrocarbon ring or a hetero ring containing a group represented by =N- in the ring and Ring R^{T2} is a hetero ring containing a group represented by =N- in the ring, it is more preferable that Ring R^{T1} is a monocyclic aromatic hydrocarbon ring or a monocyclic hetero ring containing a group represented by =N- in the ring and Ring R^{T2} is a monocyclic hetero ring containing a group represented by =N- in the ring, it is further preferable that Ring R^{T1} is a benzene ring, a pyridine ring or a diazabenzene ring and Ring R^{T2} is a pyridine ring or a diazabenzene ring, and it is particularly preferable that Ring R^{T1} is a benzene ring and Ring R^{T2} is a pyridine ring, and these rings optionally have a substituent, since the light emitting device of the present embodiment is further excellent in light emission efficiency.

The examples and preferable ranges of the substituent which Ring R^{T1} and Ring R^{T2} optionally have are the same as the examples and preferable ranges of the substituent which Ar^{H1}, Ar^{H2} and L^{H1} optionally have.

The examples and preferable ranges of the arylene group represented by L^{T1} are the same as the examples and preferable ranges of the arylene group as the arylene group represented by L^{H1}.

The examples and preferable ranges of the divalent hetero ring group represented by L^{T1} are the same as the examples and preferable ranges of the arylene group as the divalent hetero ring group represented by L^{H1}.

L^{T1} is preferably an arylene group or a divalent hetero ring group, more preferably a group obtained by removing from benzene, naphthalene, fluorene, pyridine, diazabenzene, triazine, azanaphthalene, diazanaphthalene, carbazole, dibenzofuran or dibenzothiophene two hydrogen atoms bonding directly to carbon atoms or hetero atoms constituting the ring, further preferably a group obtained by removing from benzene, fluorene, pyridine, diazabenzene, triazine, carbazole, dibenzofuran or dibenzothiophene two hydrogen atoms bonding directly to carbon atoms or hetero atoms constituting the ring, particularly preferably a group obtained by removing from benzene, dibenzofuran or dibenzothiophene two hydrogen atoms bonding directly to carbon atoms constituting the ring, and especially preferably a phenylene group, and these groups optionally have a substituent.

When a plurality of L^{T1} are present, it is preferable that they are the same, since a compound represented by the formula (T-1) can be synthesized easily.

The examples and preferable ranges of the substituent which L^{T1} optionally has are the same as the examples and preferable ranges of the substituent which Ar^{H1}, Ar^{H2} and L^{H1} optionally have.

R^{T1}' is preferably an aryl group or a monovalent hetero ring group, more preferably an aryl group, and these groups optionally have a substituent.

The examples and preferable ranges of the aryl group and the monovalent hetero ring group represented by R^{T1'} are the same as the examples and preferable ranges of the aryl group and the monovalent hetero ring group represented by Ar^{H1} and Ar^{H2}, respectively.

The examples and preferable ranges of the substituent which R^{T1}' optionally has are the same as the examples and preferable ranges of the substituent which Ar^{H1}, Ar^{H2} and L^{H1} optionally have.

The aromatic hydrocarbon group represented by Ar^{T2} is preferably a group obtained by removing from a monocyclic or 2 to 6-cyclic aromatic hydrocarbon one or more hydrogen atoms bonding directly to carbon atoms constituting the ring, more preferably a group obtained by removing from a monocyclic, 2-cyclic or 3-cyclic aromatic hydrocarbon one or more hydrogen atoms bonding directly to carbon atoms constituting the ring, and further preferably a group obtained by removing from benzene, naphthalene, fluorene, phenanthrene or anthracene one or more hydrogen atoms bonding directly to carbon atoms constituting the ring, and these groups optionally have a substituent.

The hetero ring group represented by Ar^{T2} is preferably a group obtained by removing from a monocyclic or 2 to 6-cyclic heterocyclic compound one or more hydrogen atoms bonding directly to carbon atoms or hetero atoms constituting the ring, more preferably a group obtained by removing from a monocyclic, 2-cyclic or 3-cyclic heterocyclic compound one or more hydrogen atoms bonding directly to carbon atoms or hetero atoms constituting the ring, further preferably a group obtained by removing from pyridine, diazabenzene, triazine, azanaphthalene, diazanaphthalene, carbazole, dibenzofuran, dibenzothiophene, phenoxazine, phenothiazine, azaanthracene, diazaanthracene, azaphenanthrene or diazaphenanthrene one or more hydrogen atoms bonding directly to carbon atoms or hetero atoms constituting the ring, and particularly preferably a group obtained by removing from pyridine, diazabenzene, triazine, azanaphthalene, diazanaphthalene, carbazole, dibenzofuran, dibenzothiophene, azaanthracene, diazaanthracene, azaphenanthrene or diazaphenanthrene one or more hydrogen atoms bonding directly to carbon atoms or hetero atoms constituting the ring, and these groups optionally have a substituent.

Ar^{T2} is preferably a group obtained by removing from benzene, fluorene, pyridine, diazabenzene, triazine, carbazole, dibenzofuran or dibenzothiophene one or more hydrogen atoms bonding directly to carbon atoms or hetero atoms constituting the ring, and more preferably a group obtained by removing from benzene, dibenzofuran or dibenzothiophene one or more hydrogen atoms bonding directly to carbon atoms constituting the ring, and these groups optionally have a substituent, since the light emitting device of the present embodiment is more excellent in light emission efficiency.

The examples and preferable ranges of the substituent which Ar^{T2} optionally has are the same as the examples and preferable ranges of the substituent which Ar^{H1}, Ar^{H2} and L^{H1} optionally have.

The compound represented by the formula (T-1) includes, for example, compounds represented by the following formulae and compounds ET1 to ET3 described later. In the formulae, Z^{A} and Z^{B} represent the same meaning as described above.

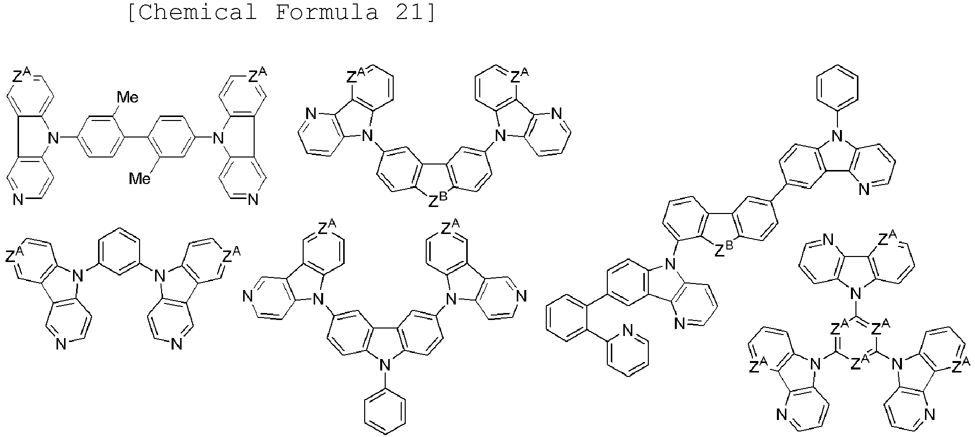

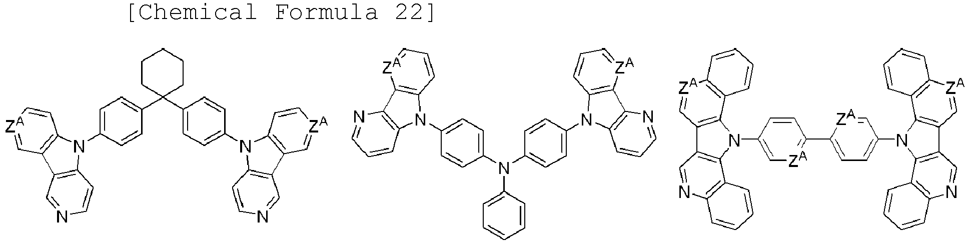

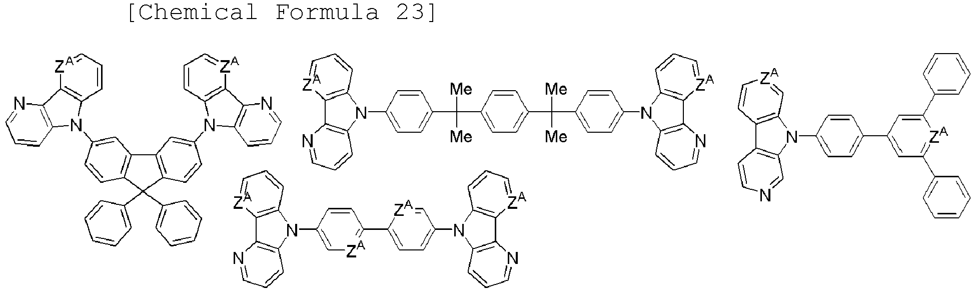

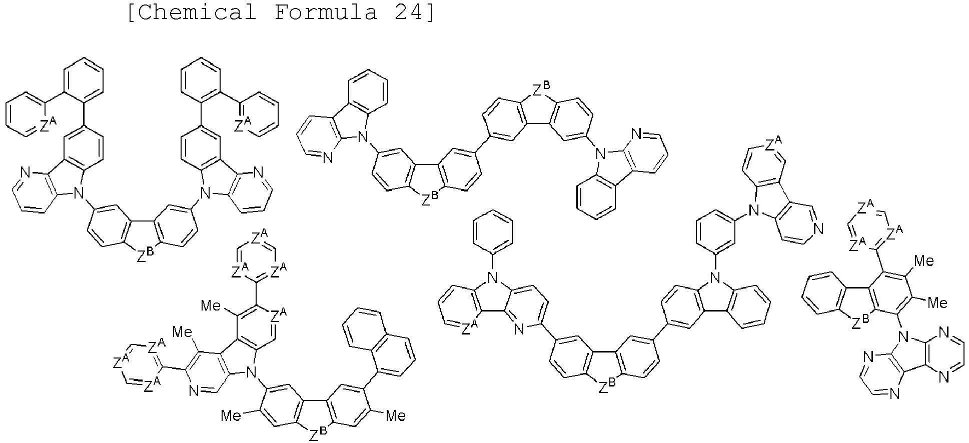

### <Compound having a crosslinkable group selected from Group A of crosslinkable group>

The compound having a crosslinkable group selected from Group A of crosslinkable group may be a low-molecular compound having a crosslinkable group selected from Group A of crosslinkable group or a polymer compound having a crosslinkable group selected from Group A of crosslinkable group, and is preferably a polymer compound having a crosslinkable group selected from Group A of crosslinkable group.

In the compound having a crosslinkable group selected from Group A of crosslinkable group, the crosslinkable group selected from Group A of crosslinkable group is preferably a crosslinkable group represented by the formula (XL-1), the formula (XL-9), the formula (XL-10), the formula (XL-16) or the formula (XL-17), more preferably a crosslinkable group represented by the formula (XL-1), the formula (XL-16) or the formula (XL-17), and further preferably a crosslinkable group represented by the formula (XL-1).

In the crosslinkable group selected from Group A of crosslinkable group, the examples and preferable ranges of the substituent which the crosslinkable group optionally has are the same as the examples and preferable ranges of the substituent which a group represented by Ar^{Y1} described later optionally has.

The compound having a crosslinkable group selected from Group A of crosslinkable group may contain one type of the crosslinkable group selected from Group A of crosslinkable group alone or may contain two or more types thereof.

### [Polymer compound having crosslinkable group selected from Group A of crosslinkable group]

It is preferable that the polymer compound having a crosslinkable group selected from Group A of crosslinkable group contains a crosslinkable group selected from Group A of crosslinkable group, as the crosslinkable constitutional unit having a crosslinkable group selected from Group A of crosslinkable group (hereinafter, referred to simply as "crosslinkable constitutional unit"). The amount of the crosslinkable constitutional unit is preferably 0.5 to 80% by mol, more preferably 3 to 65% by mol, and further preferably 5 to 50% by mol, with respect to the total amount of constitutional units contained in the polymer compound having a crosslinkable group selected from Group A of crosslinkable group, since the polymer compound having a crosslinkable group selected from Group A of crosslinkable group is excellent in stability and crosslinkability. The crosslinkable constitutional unit may be contained singly or in combination of two or more in the polymer compound having a crosslinkable group selected from Group A of crosslinkable group.

It is preferable that the polymer compound having a crosslinkable group selected from Group A of crosslinkable group further contains a constitutional unit represented by the formula (Y) described later, since the light emitting device of the present embodiment is more excellent in light emission efficiency.

It is preferable that the polymer compound having a crosslinkable group selected from Group A of crosslinkable group further contains a constitutional unit represented by the formula (X) described later, since hole transportability is excellent.

It is preferable that the polymer compound having a crosslinkable group selected from Group A of crosslinkable group further contains a constitutional unit represented by the formula (X) and a constitutional unit represented by the formula (Y), since hole transportability is excellent and since the light emitting device of the present embodiment is more excellent in light emission efficiency.

When the polymer compound having a crosslinkable group selected from Group A of crosslinkable group contains a constitutional unit represented by the formula (X), the amount of the constitutional unit represented by the formula (X) contained in the polymer compound having a crosslinkable group selected from Group A of crosslinkable group is preferably 1 to 90% by mol, more preferably 10 to 70% by mol, and further preferably 30 to 60% by mol, with respect to the total amount of constitutional units contained in the polymer compound having a crosslinkable group selected from Group A of crosslinkable group, since hole transportability is excellent.

The constitutional unit represented by the formula (X) may be contained singly or in combination of two or more in the polymer compound having a crosslinkable group selected from Group A of crosslinkable group.

When the polymer compound having a crosslinkable group selected from Group A of crosslinkable group contains a constitutional unit represented by the formula (Y) and Ar^{Y1} is an arylene group, the amount of the constitutional unit represented by the formula (Y) contained in the polymer compound having a crosslinkable group selected from Group A of crosslinkable group is preferably 1 to 90% by mol, and more preferably 30 to 80% by mol, with respect to the total amount of the polymer compound having a crosslinkable group selected from Group A of crosslinkable group, since the light emitting device of the present embodiment is more excellent in light emission efficiency.

When the polymer compound having a crosslinkable group selected from Group A of crosslinkable group contains a constitutional unit represented by the formula (Y) and Ar^{Y1} is a divalent hetero ring group or a divalent group in which at least one arylene group and at least one divalent hetero ring group are bonded directly, the amount of the constitutional unit represented by the formula (Y) contained in the polymer compound having a crosslinkable group selected from Group A of crosslinkable group is preferably 0.5 to 50% by mol, and more preferably 3 to 30% by mol, with respect to the total amount of constitutional units contained in the polymer compound having a crosslinkable group selected from Group A of crosslinkable group, since the polymer compound having a crosslinkable group selected from Group A of crosslinkable group is excellent in charge transportability.

The constitutional unit represented by the formula (Y) may be contained singly or in combination of two or more in the polymer compound having a crosslinkable group selected from Group A of crosslinkable group.

### [Constitutional unit represented by the formula (Y)]

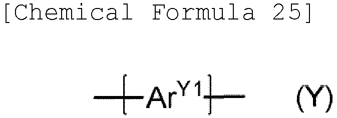

[wherein, Ar^{Y1} represents an arylene group, a divalent hetero ring group, or a divalent group in which at least one arylene group and at least one divalent hetero ring group are bonded directly, and these groups optionally have a single or a plurality of substituents. When a plurality of the above-described substituents are present, they may be the same or different and may be combined together to form a ring together with atoms to which they are attached.]

The arylene group represented by Ar^{Y1} is preferably a group obtained by removing from a monocyclic, 2-cyclic or 3-cyclic aromatic hydrocarbon two hydrogen atoms bonding directly to carbon atoms constituting the ring, more preferably a group obtained by removing from benzene, naphthalene, anthracene, phenanthrene, dihydrophenanthrene or fluorene two hydrogen atoms bonding directly to carbon atoms constituting the ring, and further preferably a group obtained by removing from benzene, phenanthrene, dihydrophenanthrene or fluorene two hydrogen atoms bonding directly to carbon atoms constituting the ring, and these optionally have a substituent, since the light emitting device of the present embodiment is more excellent in light emission efficiency.

The divalent hetero ring group represented by Ar^{Y1} is preferably a monocyclic, 2-cyclic or 3-cyclic aromatic hetero ring, more preferably a group obtained by removing from pyridine, diazabenzene, triazine, azanaphthalene, diazanaphthalene, carbazole, dibenzofuran, dibenzothiophene, phenoxazine, phenothiazine or 9,10-dihydroacridine two hydrogen atoms bonding directly to carbon atoms or nitrogen atoms constituting the ring, and further preferably a group obtained by removing from pyridine, diazabenzene, triazine, carbazole, dibenzofuran or dibenzothiophene two hydrogen atoms bonding directly to carbon atoms or nitrogen atoms constituting the ring, and these optionally have a substituent, since the light emitting device of the present embodiment is more excellent in light emission efficiency.

The preferable ranges of the arylene group and the divalent hetero ring group as the divalent group in which at least one arylene group and at least one divalent hetero ring group are bonded directly represented by Ar^{Y1} are the same as the preferable ranges of the arylene group and the divalent hetero ring group represented by Ar^{Y1}, respectively.

"The divalent group in which at least one arylene group and at least one divalent hetero ring group are bonded directly" includes, for example, groups represented by the following formulae, and these optionally have a substituent.

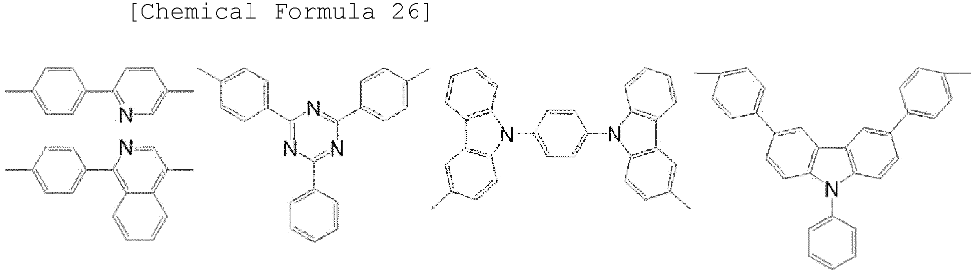

Ar^{Y1} is preferably an arylene group optionally having a substituent, since the light emitting device of the present embodiment is more excellent in light emission efficiency.

The substituent which a group represented by Ar^{Y1} optionally has is preferably an alkyl group, a cycloalkyl group, an alkoxy group, a cycloalkoxy group, an aryl group, an aryloxy group, a monovalent hetero ring group, a substituted amino group or a fluorine atom, more preferably an alkyl group, a cycloalkyl group, an alkoxy group, a cycloalkoxy group, an aryl group, monovalent hetero ring group or a substituted amino group, and further preferably an alkyl group, a cycloalkyl group or an aryl group, and these groups optionally further have a substituent.

The examples and preferable ranges of the aryl group, the monovalent hetero ring group and the substituted amino group as the substituent which a group represented by Ar^{Y1} optionally has are the same as the examples and preferable ranges of the aryl group, the monovalent hetero ring group and the substituted amino group as the substituent which Ring L¹ and Ring L² optionally have, respectively.

The substituent which the substituent which a group represented by Ar^{Y1} optionally has optionally further has is preferably an alkyl group, a cycloalkyl group, an aryl group, a monovalent hetero ring group or a substituted amino group, and more preferably an alkyl group or a cycloalkyl group, and these groups optionally further have a substituent, however, it is preferable that they do not further have a substituent.

The examples and preferable ranges of the aryl group, the monovalent hetero ring group and the substituted amino group as the substituent which the substituent which a group represented by Ar^{Y1} optionally has optionally further has are the same as the examples and preferable ranges of the aryl group, the monovalent hetero ring group and the substituted amino group as the substituent which Ring L¹ and Ring L² optionally have, respectively.

The constitutional unit represented by the formula (Y) is preferably a constitutional unit represented by the formula (Y-1) or (Y-2), since the light emitting device of the present embodiment is more excellent in light emission efficiency. 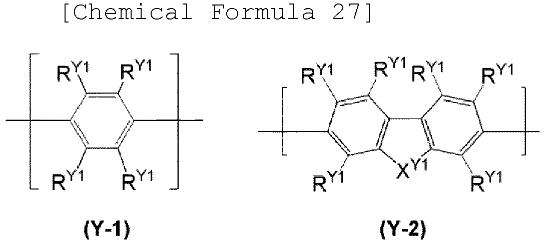 [wherein,
R^{Y1} represents a hydrogen atom, an alkyl group, a cycloalkyl group, an alkoxy group, a cycloalkoxy group, an aryl group, a monovalent hetero ring group or a substituted amino group, and these groups optionally have a single or a plurality of substituents. When a plurality of the above-described substituents are present, they may be the same or different and may be combined together to form a ring together with atoms to which they are attached. A plurality of R^{Y1} may be the same or different and may be combined together to form a ring together with carbon atoms to which they are attached.
X^{Y1} represents a group represented by -C(R^{Y2})₂-, - C(R^{Y2})=C(R^{Y2})- or C(R^{Y2})₂-C(R^{Y2})₂-. R^{Y2} represents a hydrogen atom, an alkyl group, a cycloalkyl group, an alkoxy group, a cycloalkoxy group, an aryl group, a monovalent hetero ring group or a substituted amino group, and these groups optionally have a single or a plurality of substituents. When a plurality of the above-described substituents are present, they may be the same or different and may be combined together to form a ring together with atoms to which they are attached. A plurality of R^{Y2} may be the same or different and may be combined together to form a ring together with carbon atoms to which they are attached.]

R^{Y1} is preferably a hydrogen atom, an alkyl group, a cycloalkyl group, an aryl group or a monovalent hetero ring group, more preferably a hydrogen atom, an alkyl group, a cycloalkyl group or an aryl group, and further preferably a hydrogen atom or an alkyl group, and these groups optionally have a substituent.

R^{Y2} is preferably an alkyl group, a cycloalkyl group, an aryl group or a monovalent hetero ring group, and more preferably an alkyl group, a cycloalkyl group or an aryl group, and these groups optionally have a substituent.

The examples and preferable ranges of the aryl group, the monovalent hetero ring group and the substituted amino group represented by R^{Y1} and R^{Y2} are the same as the examples and preferable ranges of the aryl group, the monovalent hetero ring group and the substituted amino group as the substituent which Ring L¹ and Ring L² optionally have, respectively.

The examples and preferable ranges of the substituent which R^{Y1} and R^{Y2} optionally have are the same as the examples and preferable ranges of the substituent which a group represented by Ar^{Y1} optionally has.

The constitutional unit represented by the formula (Y) includes, for example, constitutional units represented by the following formulae and constitutional units derived from compounds M4, M5, M8 and M9 described later. In the following formulae, Z^{A} and Z^{B} represent the same meaning as described above.

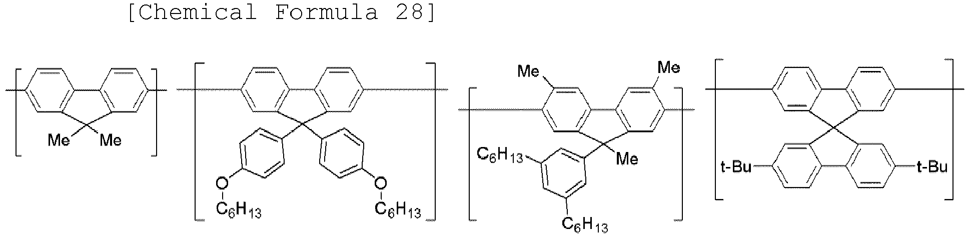

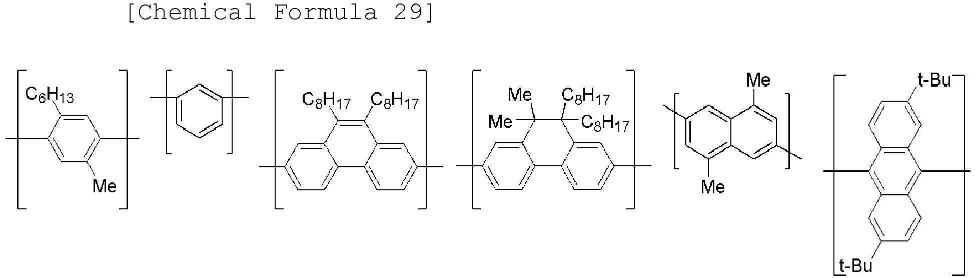

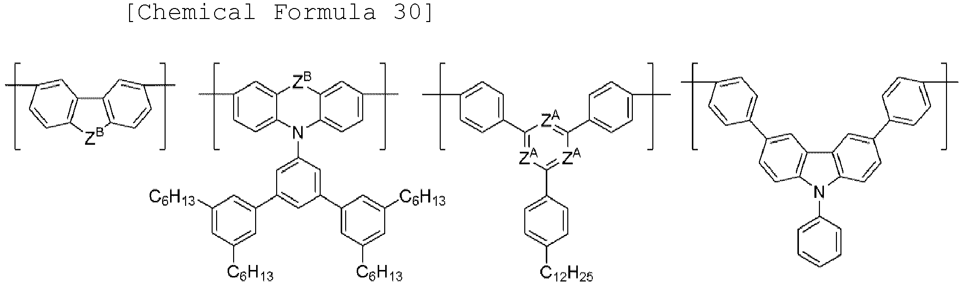

### [Constitutional unit represented by the formula (X)]

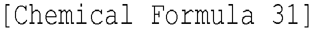

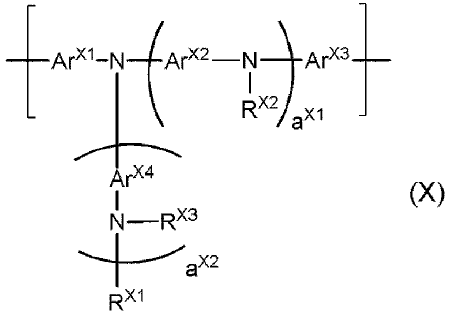

[wherein,
a^{x1} and a^{X2} each independently represent an integer of 0 or more.

Ar^{X1} and Ar^{X3} each independently represent an arylene group or a divalent hetero ring group, and these groups optionally have a single or a plurality of substituents. When a plurality of the above-described substituents are present, they may be the same or different and may be combined together to form a ring together with atoms to which they are attached.

Ar^{X2} and Ar^{X4} each independently represent an arylene group, a divalent hetero ring group, or a divalent group in which at least one arylene group and at least one divalent hetero ring group are bonded directly, and these groups optionally have a single or a plurality of substituents. When a plurality of the above-described substituents are present, they may be the same or different and may be combined together to form a ring together with atoms to which they are attached. When a plurality of Ar^{X2} and Ar^{X4} are present, they may be the same or different at each occurrence.

R^{X1}, R^{X2} and R^{X3} each independently represent a hydrogen atom, an alkyl group, a cycloalkyl group, an aryl group or a monovalent hetero ring group, and these groups optionally have a single or a plurality of substituents. When a plurality of the above-described substituents are present, they may be the same or different and may be combined together to form a ring together with atoms to which they are attached. When a plurality of R^{X2} and R^{X3} are present, they may be the same or different at each occurrence.]

a^{X1} is usually an integer of 0 to 5, and it is preferably an integer of 0 to 2, and more preferably 0 or 1, since the light emitting device of the present embodiment is more excellent in light emission efficiency.

a^{X2} is usually an integer of 0 to 5, and it is preferably an integer of 0 to 2, and more preferably 0, since the light emitting device of the present embodiment is more excellent in light emission efficiency.

R^{X1}, R^{X2} and R^{X3} are each preferably an alkyl group, a cycloalkyl group, an aryl group or a monovalent hetero ring group, and more preferably an aryl group, and these groups optionally have a substituent.

The examples and preferable ranges of the aryl group and the monovalent hetero ring group represented by R^{X1}, R^{X2} and R^{X3} are the same as the examples and preferable ranges of the aryl group and the monovalent hetero ring group as the substituent which Ring L¹ and Ring L² optionally have, respectively.

The examples and preferable ranges of the arylene group and the divalent hetero ring group represented by Ar^{X1}, Ar^{X2}, Ar^{X3} and Ar^{X4} are the same as the examples and preferable ranges of the arylene group and the divalent hetero ring group represented by Ar^{Y1}, respectively.

The examples and preferable ranges of the arylene group and the divalent hetero ring group as the divalent group in which at least one arylene group and at least one divalent hetero ring group are bonded directly represented by Ar^{X2} and Ar^{X4} are the same as the examples and preferable ranges of the arylene group and the divalent hetero ring group represented by Ar^{Y1}, respectively.

The divalent group in which at least one arylene group and at least one divalent hetero ring group are bonded directly represented by Ar^{X2} and Ar^{X4} includes the same examples as for the divalent group in which at least one arylene group and at least one divalent hetero ring group are bonded directly represented by Ar^{Y1}.

Ar^{X1}, Ar^{X2}, Ar^{X3} and Ar^{X4} are each preferably an arylene group optionally having a substituent.

The examples and preferable ranges of the substituent which a group represented by Ar^{X1} to Ar^{X4} and R^{X1} to R^{X3} optionally has are the same as the examples and preferable ranges of the substituent which a group represented by Ar^{Y1} optionally has.

The constitutional unit represented by the formula (X) includes, for example, constitutional units represented by the following formulae and constitutional units derived from compounds M3 and M6 described later. In the following formulae, Z^{B} represent the same meaning as described above.

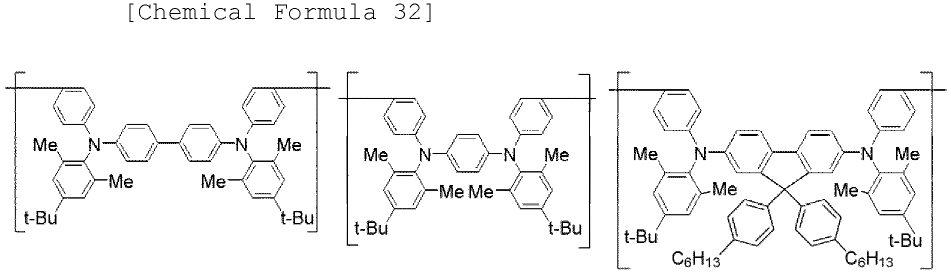

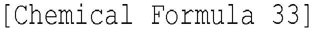

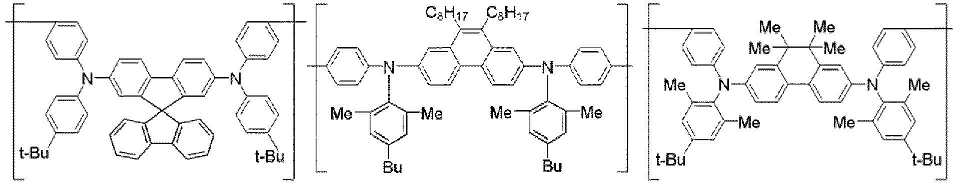

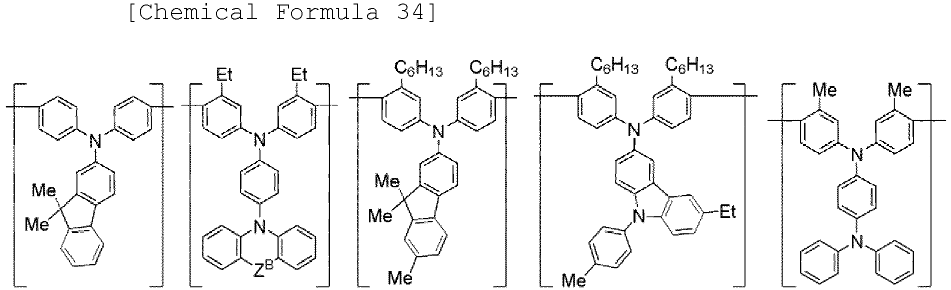

### [Crosslinkable constitutional unit]

The crosslinkable constitutional unit is preferably a constitutional unit represented by the formula (Z) or a constitutional unit represented by the formula (Z').

### [Constitutional unit represented by the formula (Z)]

n is usually an integer of 1 to 5, and it is preferably an integer of 1 to 4, and more preferably 1 or 2, since the light emitting device of the present embodiment is more excellent in light emission efficiency.

nA is usually an integer of 0 to 5, and it is preferably an integer of 0 to 4, and more preferably an integer of 0 to 2, since the light emitting device of the present embodiment is more excellent in light emission efficiency.

Ar³ is preferably an aromatic hydrocarbon group optionally having a substituent, since the light emitting device of the present embodiment is more excellent in light emission efficiency.

The examples and preferable ranges of the arylene group portion obtained by removing n substituents of the aromatic hydrocarbon group represented by Ar³ are the same as the examples and preferable ranges of the arylene group represented by Ar^{Y1}.

The examples and preferable ranges of the divalent hetero ring group portion obtained by removing n substituents of the hetero ring group represented by Ar³ are the same as the examples and preferable ranges of the divalent hetero ring group represented by Ar^{Y1}.

The examples and preferable ranges of the divalent group obtained by removing n substituents of the group in which at least one aromatic hydrocarbon group and at least one hetero ring group are bonded directly represented by Ar³ are the same as the examples and preferable ranges of the divalent group in which at least one arylene group and at least one divalent hetero ring group are bonded directly represented by Ar^{Y1}.

The examples and preferable ranges of the arylene group represented by L^{A} are the same as the examples and preferable ranges of the arylene group represented by Ar^{Y1}, and the arylene group represented by L^{A} is preferably a phenylene group or a fluorenediyl group, and these groups optionally further have a substituent, since the light emitting device of the present embodiment is further excellent in light emission efficiency.

The examples and preferable ranges of the divalent hetero ring group represented by L^{A} are the same as the examples and preferable ranges of the divalent hetero ring group represented by Ar^{Y1}.

L^{A} is preferably an arylene group or an alkylene group, and more preferably a phenylene group, a fluorenediyl group or an alkylene group, and these groups optionally have a substituent, since synthesis of the polymer compound having a crosslinkable group selected from Group A of crosslinkable group is easy.

R' is preferably an aryl group or a monovalent hetero ring group, and more preferably an aryl group, and these groups optionally have a substituent.

The examples and preferable ranges of the aryl group and the monovalent hetero ring group represented by R' are the same as the examples and preferable ranges of the aryl group and the monovalent hetero ring group as the substituent which Ring L¹ and Ring L² optionally have, respectively.

The examples and preferable ranges of the substituent which a group represented by Ar³, L^{A} and R' optionally has are the same as the examples and preferable ranges of the substituent which a group represented by Ar^{Y1} optionally has.

The examples and preferable ranges of the crosslinkable group selected from Group A of crosslinkable group represented by X are the same as the examples and preferable ranges of the crosslinkable group in the compound having a crosslinkable group selected from Group A of crosslinkable group.

### [Constitutional unit represented by the formula (Z')]

mA is usually an integer of 0 to 5, and it is preferably an integer of 0 to 4, more preferably an integer of 0 to 2, further preferably 0 or 1, particularly preferably 0, since the light emitting device of the present embodiment is more excellent in light emission efficiency.

m is usually an integer of 0 to 5, and it is preferably an integer of 0 to 4, more preferably an integer of 0 to 2, since the light emitting device of the present embodiment is more excellent in light emission efficiency.

c is usually an integer of 0 to 5, and it is preferably an integer of 0 to 2, and more preferably 0 or 1, since production of a polymer compound of the present embodiment is easy and since the light emitting device of the present embodiment is more excellent in light emission efficiency.

Ar⁵ is preferably an aromatic hydrocarbon group optionally having a substituent, since the light emitting device of the present embodiment is more excellent in light emission efficiency.

The examples and preferable ranges of the arylene group portion obtained by removing m substituents of the aromatic hydrocarbon group represented by Ar⁵ are the same as the examples and preferable ranges of the arylene group represented by Ar^{X1}, Ar^{X2}, Ar^{X3} and Ar^{X4}.

The examples and preferable ranges of the divalent hetero ring group portion obtained by removing m substituents of the hetero ring group represented by Ar⁵ are the same as the examples and preferable ranges of the divalent hetero ring group portion represented by Ar^{X1}, Ar^{X2}, Ar^{X3} and Ar^{X4}.

The examples and preferable ranges of the divalent group obtained by removing m substituents of the group in which at least one aromatic hydrocarbon group and at least one hetero ring group are bonded directly represented by Ar⁵ are the same as the examples and preferable ranges of the divalent group in which at least one arylene group and at least one divalent hetero ring group are bonded directly represented by Ar^{X2} and Ar^{X4}.

Ar⁴ and Ar⁶ are each preferably an arylene group optionally having a substituent, since the light emitting device of the present embodiment is more excellent in light emission efficiency.

The examples and preferable ranges of the arylene group represented by Ar⁴ and Ar⁶ are the same as the examples and preferable ranges of the arylene group represented by Ar^{X1}, Ar^{X2}, Ar^{X3} and Ar^{X4}.

The examples and preferable ranges of the divalent hetero ring group represented by Ar⁴ and Ar⁶ are the same as the examples and preferable ranges of the divalent hetero ring group represented by Ar^{X1}, Ar^{X2}, Ar^{X3} and Ar^{X4}.

The examples and preferable ranges of the substituent which a group represented by Ar⁴ to Ar⁶ optionally has are the same as the examples and preferable ranges of the substituent which a group represented by Ar^{Y1} optionally has.

The examples and preferable ranges of K^{A} are the same as the examples and preferable ranges of L^{A}.

The examples and preferable ranges of R" are the same as the examples and preferable ranges of R'.

The examples and preferable ranges of the crosslinkable group selected from Group A of crosslinkable group represented by X' are the same as the examples and preferable ranges of the crosslinkable group selected from Group A of crosslinkable group represented by X.

The examples and preferable ranges of the aryl group and the monovalent hetero ring group represented by X' are the same as the examples and preferable ranges of the aryl group and the monovalent hetero ring group as the substituent which Ring L¹ and Ring L² optionally have, respectively.

X' is preferably a crosslinkable group selected from Group A of crosslinkable group, an alkyl group, a cycloalkyl group, an aryl group or a monovalent hetero ring group, and more preferably a crosslinkable group selected from Group A of crosslinkable group, an alkyl group or an aryl group, and these groups optionally have a substituent.

The examples and preferable ranges of the substituent which a group represented by X' optionally has are the same as the examples and preferable ranges of the substituent which a group represented by Ar^{Y1} optionally has.

The crosslinkable constitutional unit includes, for example, constitutional units represented by the following formulae and constitutional units derived from compounds M1, M2, M7, M10 and M11 described later. In the following formulae, Z^{B} represent the same meaning as described above. X^{A} represents a crosslinkable group selected from Group A of crosslinkable group. When a plurality of X^{A} are present, they may be the same or different. The preferable ranges of X^{A} are the same as the preferable ranges of the crosslinkable group selected from Group A of crosslinkable group in the compound having a crosslinkable group selected from Group A of crosslinkable group.

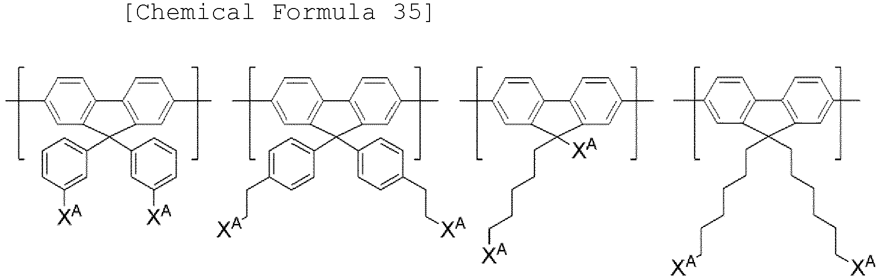

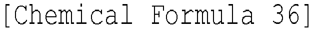

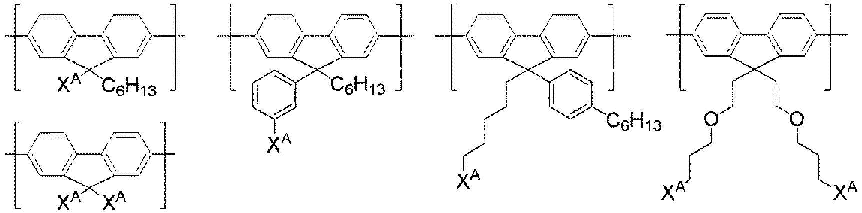

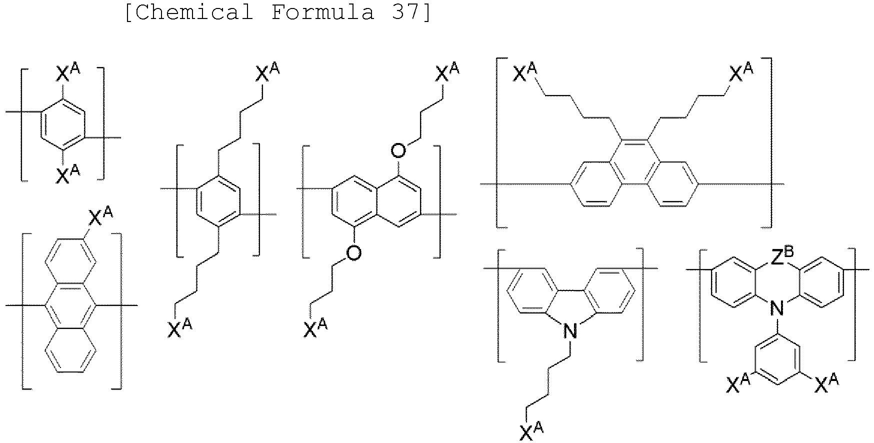

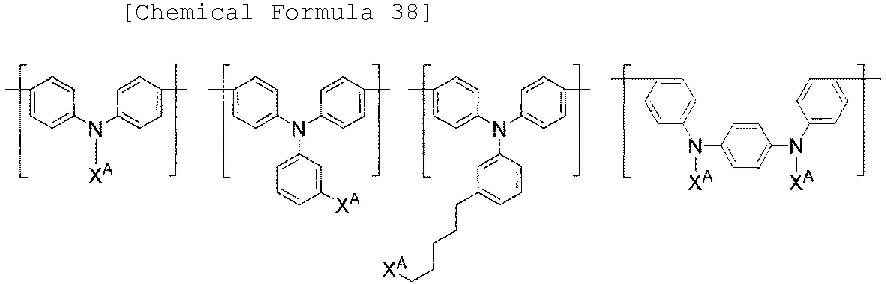

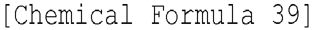

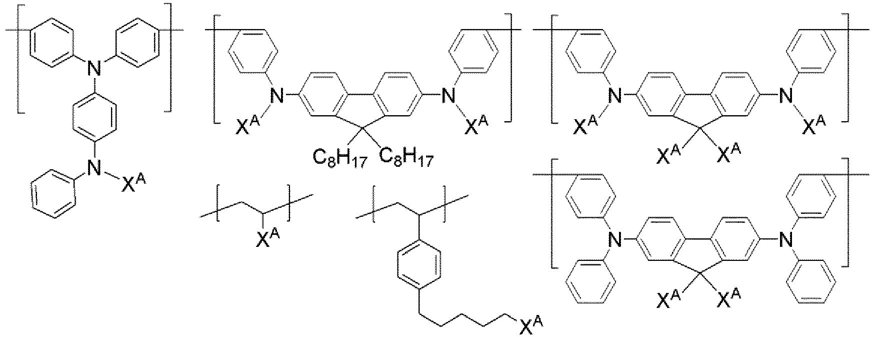

The polymer compound having a crosslinkable group selected from Group A of crosslinkable group includes, for example, polymer compounds P-1 to P-8. "Other" denotes constitutional units other than constitutional units represented by the formula (Z), the formula (Z'), the formula (X) and the formula (Y).

**[Table 1]**

| Polymer compound | Constitutional unit and molar ratio thereof | | | | |
|---|---|---|---|---|---|
| | Formula (Z) | Formula (Z') | Formula (X) | Formula (Y) | other |
| | p' | q' | r' | s' | t' |
| P-1 | 0.1∼99.9 | 0.1∼99.9 | 0 | 0 | 0∼30 |
| P-2 | 0.1∼99.9 | 0 | 0.1∼99.9 | 0 | 0∼30 |
| P-3 | 0.1∼99.9 | 0 | 0 | 0.1∼99.9 | 0∼30 |
| P-4 | 0 | 0.1∼99.9 | 0.1∼99.9 | 0 | 0∼30 |
| P-5 | 0 | 0.1∼99.9 | 0 | 0.1∼99.9 | 0∼30 |
| P-6 | 0.1∼99.8 | 0.1∼99.8 | 0.1∼99.8 | 0 | 0∼30 |
| P-7 | 0.1∼99.8 | 0.1∼99.8 | 0 | 0.1∼99.8 | 0∼30 |
| P-8 | 0.1∼99.7 | 0.1∼99.7 | 0.1∼99.7 | 0.1∼99.7 | 0∼30 |

[in the table, p', q', r', s' and t' represent the molar ratio (% by mol) of each constitutional unit. p'+q'+r'+s'+t'=100 and 70 ≤ p'+q'+r'+s' ≤ 100.]

The polymer compound having a crosslinkable group selected from Group A of crosslinkable group may be any of a block copolymer, a random copolymer, an alternative copolymer and a graft copolymer and may also be in other form, and is preferably a copolymer obtained by copolymerizing multiple types of raw material monomers.

The polystyrene-equivalent number-average molecular weight of the polymer compound having a crosslinkable group selected from Group A of crosslinkable group is preferably 5×10³ to 1×10⁶, more preferably 1×10⁴ to 5×10⁵, and further preferably 1.5×10⁴ to 1.5×10⁵.

### [Production method of polymer compound having crosslinkable group selected from Group A of crosslinkable group]

The polymer compound having a crosslinkable group selected from Group A of crosslinkable group can be synthesized using known polymerization methods described in Chemical Review (Chem. Rev.), vol. 109, pp. 897-1091 (2009) and the like, and exemplified are methods for polymerization by a coupling reaction using a transition metal catalyst such as the Suzuki reaction, the Yamamoto reaction, the Buchwald reaction, the Stille reaction, the Negishi reaction, the Kumada reaction and the like.

### [Low-molecular compound having crosslinkable group selected from Group A of crosslinkable group]

The low-molecular compound having a crosslinkable group selected from Group A of crosslinkable group is preferably a low-molecular compound represented by the formula (Z").

The examples and preferable ranges of m^{B1} are the same as the examples and preferable ranges of mA.

The examples and preferable ranges of m^{B2} are the same as the examples and preferable ranges of c.

The examples and preferable ranges of m^{B3} are the same as the examples and preferable ranges of m.

The examples and preferable ranges of Ar⁷ are the same as the examples and preferable ranges of Ar⁵.

The examples and preferable ranges of L^{B1} are the same as the examples and preferable ranges of L^{A}.

The examples and preferable ranges of R''' are the same as the examples and preferable ranges of R'.

The examples and preferable ranges of X" are the same as the examples and preferable ranges of X'.

The low-molecular compound having a crosslinkable group selected from Group A of crosslinkable group includes, for example, low-molecular compounds shown below.

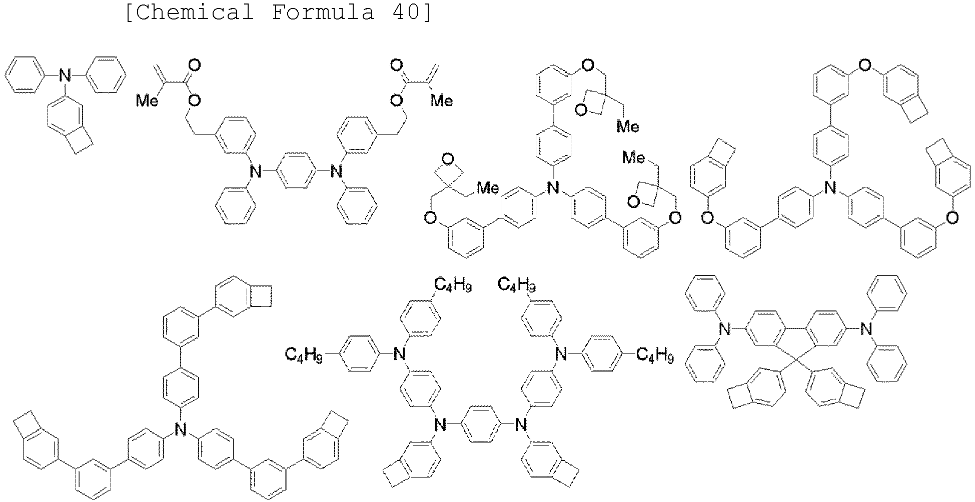

### <Light emitting device>

The light emitting device of the present embodiment is a light emitting device having an anode, a cathode, a first layer disposed between the anode and the cathode, and a second layer disposed between the anode and the first layer, wherein the second layer is a layer containing a crosslinked product of the compound having a crosslinkable group selected from Group A of crosslinkable group, and at least one of the first layer and the second layer contains a compound represented by the formula (T-1).

It is more preferable that the compound represented by the formula (T-1) is contained in the first layer, since the light emitting device of the present embodiment is more excellent in light emission efficiency.

### <Second layer>

In the light emitting device of the present embodiment, the second layer is a layer containing a crosslinked product of the compound having a crosslinkable group selected from Group A of crosslinkable group. The second layer may contain one type of a crosslinked product of the compound having a crosslinkable group selected from Group A of crosslinkable group alone or may contain two or more types thereof.

In the second layer in the light emitting device of the present embodiment, the content of a crosslinked product of the compound having a crosslinkable group selected from Group A of crosslinkable group may be in the range where the function as the second layer is performed. For example, the content of a crosslinked product of the compound having a crosslinkable group selected from Group A of crosslinkable group may be 1% by mass or more and 100% by mass or less based on the total amount of the second layer, and it is preferably 30% by mass or more and 100% by mass or less, more preferably 60% by mass or more and 100% by mass or less, further preferably 90% by mass or more and 100% by mass or less, and particularly preferably 100% by mass.

In the light emitting device of the present embodiment, when the second layer contains a compound represented by the formula (T-1), the second layer may contain one type of the compound represented by the formula (T-1) alone, or may contain two or more types thereof.

In the light emitting device of the present embodiment, when the second layer contains a compound represented by the formula (T-1), the content of the compound represented by the formula (T-1) is usually 1 part by mass or more and 1000 parts by mass or less when the content of a crosslinked product of the compound having a crosslinkable group selected from Group A of crosslinkable group is taken as 100 parts by mass.

### [Composition 2]

The second layer may be a layer containing a composition containing a crosslinked product of the compound having a crosslinkable group selected from Group A of crosslinkable group and at least one selected from the group consisting of a compound represented by the formula (T-1), a hole transporting material, a hole injection material, an electron transporting material, an electron injection material, a light emitting material and an antioxidant (hereinafter, referred to also as "composition 2"). However, in the composition 2; the hole transporting material, the hole injection material, the electron transporting material, the electron injection material and the light emitting material are different from the crosslinked product of the compound having a crosslinkable group selected from Group A of crosslinkable group and the compound represented by the formula (T-1).

### [Hole transporting material]

The hole transporting material is classified into a low-molecular compound and a polymer compound, and is preferably a polymer compound. The hole transporting material may have a crosslinkable group.

The low-molecular compound includes, for example, aromatic amine compounds such as triphenylamine and derivatives thereof, N,N'-di-1-naphthyl-N,N'-diphenylbenzidine (a-NPD), and, N,N'-diphenyl-N,N'-di(m-tolyl)benzidine (TPD) and the like.

The polymer compound includes, for example, polyvinylcarbazoles and derivatives thereof; polyarylenes having an aromatic amine structure in the side chain or main chain, and derivatives thereof. The polymer compound may be a compound to which an electron accepting site is bonded. The electron accepting site includes, for example, fullerenes, tetrafluorotetracyanoquinodimethane, tetracyanoethylene, trinitrofluorenone and the like, preferably fullerenes.

In the composition 2, the content of the hole transporting material is usually 1 part by mass or more and 1000 parts by mass or less, when the content of a crosslinked product of the compound having a crosslinkable group selected from Group A of crosslinkable group is taken as 100 parts by mass.

The hole transporting material may be used singly or in combination of two or more.

### [Electron transporting material]

The electron transporting material is classified into a low-molecular compound and a polymer compound. The electron transporting material may have a crosslinkable group.

The low-molecular compound includes, for example, a metal complex having 8-hydroxyquinoline as a ligand; oxadiazole, anthraquinodimethane, benzoquinone, naphthoquinone, anthraquinone, tetracyanoanthraquinodimethane, fluorenone, diphenyldicyanoethylene and diphenoquinone, and, derivatives thereof.

The polymer compound includes, for example, polyphenylene, polyfluorene, and derivatives thereof. The polymer compound may be doped with a metal.

In the composition 2, the content of the electron transporting material is usually 1 part by mass or more and 1000 parts by mass or less, when the content of a crosslinked product of the compound having a crosslinkable group selected from Group A of crosslinkable group is taken as 100 parts by mass.

The electron transporting material may be used singly or in combination of two or more.

### [Hole injection material and electron injection material]

The hole injection material and the electron injection material are each classified into a low-molecular compound and a polymer compound. The hole injection material and the electron injection material may have a crosslinkable group.

The low-molecular compound includes, for example, metal phthalocyanines such as copper phthalocyanine and the like; carbon; metal oxides such as molybdenum, tungsten and the like; and metal fluorides such as lithium fluoride, sodium fluoride, cesium fluoride, potassium fluoride and the like.

The polymer compound includes, for example, conductive polymers such as polyaniline, polythiophene, polypyrrole, polyphenylenevinylene, polythienylenevinylene, polyquinoline and polyquinoxaline, and derivatives thereof; and polymers containing an aromatic amine structure in the main chain or side chain, and the like.

In the composition 2, the contents of the hole injection material and the electron injection material are each usually 1 part by mass or more and 1000 parts by mass or less, when the content of a crosslinked product of the compound having a crosslinkable group selected from Group A of crosslinkable group is taken as 100 parts by mass.

The electron injection material and the hole injection material may each be used singly or in combination of two or more.

### [Ion doping]

When the hole injection material or the electron injection material contains a conductive polymer, the electrical conductivity of the conductive polymer is preferably 1 × 10⁻⁵ S/cm or more and 1 × 10³ S/cm or less. In order to set the electric conductivity of the conductive polymer within the above range, the conductive polymer can be doped with an appropriate amount of ions.

The types of ions to be doped are anions for hole injection materials and cations for electron injection materials. The anion includes, for example, a polystyrenesulfonate ion, an alkylbenzenesulfonate ion and a camphorsulfonate ion. The cation includes, for example, a lithium ion, a sodium ion, a potassium ion, and a tetrabutylammonium ion.

The ions to be doped may be used singly or in combination of two or more.

### [Light emitting material]

The light emitting material is classified into a low-molecular compound and a polymer compound. The light emitting material may have a crosslinkable group.

The low-molecular compound includes, for example, naphthalene and derivatives thereof, anthracene and derivatives thereof, perylene and derivatives thereof, and phosphorescent compounds having iridium, platinum or europium as a central metal.

The phosphorescent compound includes, for example, metal complexes shown below and a metal complex represented by the formula (1).

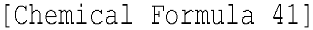

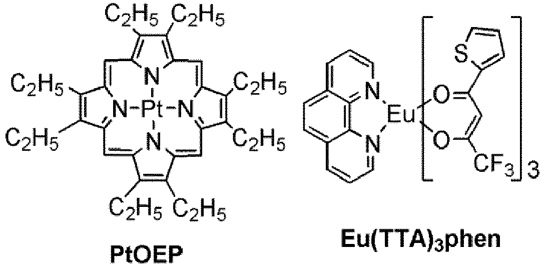

The polymer compound includes, for example, arylene groups such as a phenylene group, a naphthalenediyl group, a fluorenediyl group, a phenanthrenediyl group, a dihydrophenanthrenediyl group, an anthracenediyl group and a pyrenediyl group and the like; aromatic amine residues such as a group obtained by removing from an aromatic amine two hydrogen atoms, and the like; and polymer compounds containing a divalent hetero ring group such as a carbazolediyl group, a phenoxazinediyl group and a phenothiazinediyl group and the like.

In the composition 2, the content of the light emitting material is usually 1 part by mass or more and 1000 parts by mass or less, when the content of a crosslinked product of the compound having a crosslinkable group selected from Group A of crosslinkable group is taken as 100 parts by mass.

The light emitting material may be used singly or in combination of two or more.

### [Antioxidant]

The antioxidant may be a compound that is soluble in the same solvent as for the compound having a crosslinkable group selected from Group A of crosslinkable group and does not inhibit light emission and charge transportation, and includes, for example, a phenol-based antioxidant and a phosphorus-based antioxidant.

In the composition 2, the blending amount of the antioxidant is usually 0.001 parts by mass or more and 10 parts by mass or less, when the content of a crosslinked product of the compound having a crosslinkable group selected from Group A of crosslinkable group is taken as 100 parts by mass.

The antioxidant may be used singly or in combination of two or more.

### [Ink 2]

The second layer can be formed using, for example, a composition containing a compound having a crosslinkable group selected from Group A of crosslinkable group and a solvent (hereinafter, referred to also as "ink 2"). The ink 2 can be suitably used for wet methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method and the like.

The viscosity of the ink 2 may be adjusted according to the type of the wet method, but when applied to a printing method in which a solution passes through an ejection device such as an inkjet printing method and the like, it is preferably 1 mPa•s or more and 20 mPa•s or less at 25°C since it is difficult for clogging and flight bending during discharge to occur.

The solvent contained in the ink 2 is preferably a solvent capable of dissolving or uniformly dispersing the solid content in the ink. The solvent includes, for example, chlorine-based solvents, ether solvents, aromatic hydrocarbon solvents, aliphatic hydrocarbon solvents, ketone solvents, ester solvents, polyhydric alcohol solvents, alcohol solvents, sulfoxide solvents and amide solvents. The solvent may be used singly or in combination of two or more.

In the ink 2, the content of the solvent is usually 1000 parts by mass or more and 100000 parts by mass or less, when the content of a compound having a crosslinkable group selected from Group A of crosslinkable group is taken as 100 parts by mass.

### <First layer>

In the light emitting device of the present embodiment, at least one of the first layer and the second layer contains a compound represented by the formula (T-1), and it is preferable that the first layer contains a compound represented by the formula (T-1) since the light emitting device of the present embodiment is excellent in light emission efficiency. The first layer may contain one type of a compound represented by the formula (T-1) alone or may contain two or more types thereof.

In the light emitting device of the present embodiment, when the first layer contains a compound represented by the formula (T-1), the content of the compound represented by the formula (T-1) may be in the range where the function as the first layer is performed. For example, the content of the compound represented by the formula (T-1) may be 1% by mass or more and 100% by mass or less based on the total amount of the first layer, and it is preferably 30% by mass or more and 100% by mass or less, more preferably 60% by mass or more and 100% by mass or less, further preferably 90% by mass or more and 100% by mass or less, and particularly preferably 100% by mass.

### [Composition 1]

When the first layer contains a compound represented by the formula (T-1), the first layer may be a layer containing a composition containing a compound represented by the formula (T-1) and, at least one material selected from the group consisting of a hole transporting material, a hole injection material, an electron transporting material, an electron injection material, a light emitting material and an antioxidant (hereinafter, referred to also as "composition 1"). However, in the composition 1; the hole transporting material, the hole injection material, the electron transporting material, the electron injection material and the light emitting material are different from the compound represented by the formula (T-1).

The examples and preferable ranges of the hole transporting material, the electron transporting material, the hole injection material, the electron injection material and the light emitting material contained in the composition 1 are the same as the examples and preferable ranges of the hole transporting material, the electron transporting material, the hole injection material, the electron injection material and the light emitting material contained in the composition 2.

In the composition 1, the contents of the hole transporting material, the electron transporting material, the hole injection material, the electron injection material and the light emitting material are each usually 1 part by mass or more and 1000 parts by mass or less, when the content the compound represented by the formula (T-1) is taken as 100 parts by mass.

The examples and preferable ranges of the antioxidant contained in the composition 1 are the same as the examples and preferable ranges of the antioxidant contained in the composition 2. In the composition 1, the content of the antioxidant is usually 0.001 parts by mass or more and 10 parts by mass or less, when the content of the compound represented by the formula (T-1) is taken as 100 parts by mass.

When the first layer contains a compound represented by the formula (T-1), the first layer can be formed using, for example, a composition containing a compound represented by the formula (T-1) and a solvent (hereinafter, referred to also as "ink 1"). The ink 1 can be suitably used for the wet methods described in the section of the ink 2. The preferable ranges of the viscosity of the ink 1 are the same as the preferable ranges of the viscosity of the ink 2. The examples and preferable ranges of the solvent contained in the ink 1 are the same as the examples and preferable ranges of the solvent contained in the ink 2.

In the ink 1, the content of the solvent is usually 1000 parts by mass or more and 100000 parts by mass or less, when the content of the compound represented by the formula (T-1) is taken as 100 parts by mass.

### <Third layer>

It is preferable that the light emitting device of the present embodiment further has a third layer disposed between an anode and a cathode. The third layer is preferably a layer containing a light emitting material. When the third layer is a layer containing a light emitting material, the third layer may contain one type of the light emitting material alone or may contain two or more types thereof. The examples and preferable ranges of the light emitting material which may be contained in the third layer are the same as the examples and preferable ranges of the light emitting material contained in the composition 2.

The light emitting material which may be contained in the third layer is preferably a metal complex represented by the formula (1), since the light emitting device of the present embodiment is more excellent in light emission efficiency.

When the third layer is a layer containing a light emitting material, the content of the light emitting material may be in the range wherein the function as the third layer is performed. For example, the content of the light emitting material may be 0.1% by mass or more and 100% by mass or less based on the total amount of the third layer, and it is preferably 1% by mass or more and 70% by mass or less, more preferably 5% by mass or more and 50% by mass or less, and further preferably 10% by mass or more and 35% by mass or less.

In the light emitting device of the present embodiment, the third layer may contain a compound represented by the formula (H-1) or a compound represented by the formula (T-1). In the light emitting device of the present embodiment, when the third layer contains a compound represented by the formula (H-1) or a compound represented by the formula (T-1), it is preferable that these compounds are contained in the third layer as a host material described later. The third layer may contain one type of the compound represented by the formula (H-1) alone or may contain two or more types thereof. The third layer may contain one type of the compound represented by the formula (T-1) alone or may contain two or more types thereof.

### [Host material]

When the third layer is a layer containing a light emitting material, it is preferable that the third layer further contains a host material having at least one function selected from hole injectability, hole transportability, electron injectability and electron transportability, since the light emitting device of the present embodiment is more excellent in light emission efficiency. The third layer may contain one type of the host material alone or may contain two or more types thereof.

When the third layer is a layer containing a light emitting material and a host material, the content of the host material is usually 1 part by mass or more and 99 parts by mass or less, preferably 10 parts by mass or more and 95 parts by mass or less, more preferably 30 parts by mass or more and 90 parts by mass or less, and further preferably 50 parts by mass or more and 85 parts by mass or less, when the total content of the light emitting material and the host material is taken as 100 parts by mass.

It is preferable that the lowest excited triplet state (T₁) of the host material is at higher energy level than the lowest excited triplet state (T₁) of the light emitting material, since the light emitting device of the present embodiment is more excellent in light emission efficiency.

The host material is preferably one showing solubility in a solvent capable of dissolving a light emitting material, since the light emitting device of the present embodiment can be fabricated by a wet method.

The host material is classified into a low-molecular compound (low-molecular host) and a polymer compound (polymer host), and the third layer may contain any host material. The host material which may be contained in the third layer is preferably a low-molecular compound.

The low-molecular host includes, for example, low-molecular compounds as the hole transporting material described later and low-molecular compounds as the electron transporting material described later, and is preferably a compound represented by the formula (H-1) or a compound represented by the formula (T-1), and more preferably a compound represented by the formula (H-1).

The polymer host includes, for example, polymer compounds as the hole transporting material described later and polymer compounds as the electron transporting material described later.

### [Composition 3]

The third layer may be a layer containing a composition containing a light emitting material and at least one selected from the group consisting of the host material, the hole transporting material, the hole injection material, the electron transporting material, the electron injection material and the antioxidant described above (hereinafter, referred to also as "composition 3").

The examples and preferable ranges of the hole transporting material, the electron transporting material, the hole injection material and the electron injection material contained in the composition 3 are the same as the examples and preferable ranges of the hole transporting material, the electron transporting material, the hole injection material and the electron injection material contained in the composition 3.

In the composition 3, the contents of the hole transporting material, the electron transporting material, the hole injection material and the electron injection material are each usually 1 part by mass or more and 10000 parts by mass or less, when the content of the light emitting material is taken as 100 parts by mass.

The examples and preferable ranges of the antioxidant contained in the composition 3 are the same as the examples and preferable ranges of the antioxidant contained in the composition 3. In the composition 3, the content of the antioxidant is usually 0.00001 parts by mass or more and 10 parts by mass or less, when the content of the light emitting material is taken as 100 parts by mass.

When a light emitting material is contained in the third layer, the third layer can be formed using, for example, a composition containing a light emitting material and a solvent (hereinafter, referred to also as "ink 3"). The ink 3 can be suitably used for the wet methods described in the section of the ink 2. The preferable ranges of the viscosity of the ink 3 are the same as the preferable ranges of the viscosity of the ink 2. The examples and preferable ranges of the solvent contained in the ink 3 are the same as the examples and preferable ranges of the solvent contained in the ink 2.

In the ink 3, the content of the solvent is usually 1000 parts by mass or more and 1000000 parts by mass or less, when the content of the light emitting material is taken as 100 parts by mass.

### <Layer constitution of light emitting device>

FIG. 1 is a schematic cross-sectional view of the light emitting device according to one embodiment of the present invention. The light emitting device 10 shown in FIG. 1 has an anode 11, a cathode 14, a first layer 13 disposed between the anode 11 and the cathode 14, and a second layer 12 disposed between the anode 11 and the first layer 13.

The light emitting device of the present embodiment may contain other layers than the anode 11, the cathode 14, the first layer 13 and the second layer 12.

In the light emitting device of the present embodiment, when the third layer is present, the light emitting device of the present embodiment may have other layers than the anode 11, the cathode 14, the first layer 13, the second layer 12 and the third layer.

In the light emitting device of the present embodiment, the first layer 13 is usually a light emitting layer (hereinafter, referred to as "first light emitting layer"), an electron transporting layer or an electron injection layer, and more preferably an electron transporting layer.

In the light emitting device of the present embodiment, the second layer 12 is usually a light emitting layer (a light emitting layer different from the first light emitting layer, hereinafter, referred to as "second light emitting layer"), a hole transporting layer or a hole injection layer, more preferably a second light emitting layer or a hole transporting layer, and further preferably a hole transporting layer.

In the light emitting device of the present embodiment, when the third layer is present, the third layer is usually a light emitting layer (a light emitting layer different from the first light emitting layer and the second light emitting layer, hereinafter, referred to as "third light emitting layer").

In the light emitting device of the present embodiment, the first layer 13 is preferably a first light emitting layer, an electron transporting layer or an electron injection layer disposed between the cathode 14 and the second layer 12, and more preferably an electron transporting layer disposed between the cathode 14 and the second layer 12.

In the light emitting device of the present embodiment, the second layer 12 is preferably a second light emitting layer, a hole transporting layer or a hole injection layer disposed between the anode 11 and the first layer 13, more preferably a second light emitting layer or a hole transporting layer disposed between the anode 11 and the second layer 12, and further preferably a hole transporting layer disposed between the anode 11 and the second layer 12.

In the light emitting device of the present embodiment, when the third layer is present, the third layer is preferably a layer disposed between the second layer 12 and the first layer 13, and more preferably a third light emitting layer disposed between the second layer 12 and the first layer 13.

In the light emitting device of the present embodiment, when the third layer is present, it is preferable that the third layer is adjacent to the first layer 13, since the light emitting device of the present embodiment is more excellent in light emission efficiency.

In the light emitting device of the present embodiment, when the third layer is present, it is preferable that the third layer is adjacent to the second layer 12, since the light emitting device of the present embodiment is more excellent in light emission efficiency.

In the light emitting device of the present embodiment, when the third layer is present, it is preferable that the third layer is adjacent to the first layer 13 and the second layer 12, since the light emitting device of the present embodiment is further excellent in light emission efficiency.

The light emitting device of the present embodiment has at least one of a first light emitting layer, a second light emitting layer and a third light emitting layer. The light emitting device of the present embodiment preferably has at least one of a second light emitting layer and a third light emitting layer, and further preferably has a third light emitting layer, since the light emitting device of the present embodiment is more excellent in light emission efficiency.

The light emitting device of the present embodiment preferably further has at least one of a hole injection layer and a hole transporting layer between the anode 11 and at least one of a third light emitting layer, a first light emitting layer and a second light emitting layer, since the light emitting device of the present embodiment is more excellent in light emission efficiency. The light emitting device of the present embodiment preferably further has at least one of an electron injection layer and an electron transporting layer between the cathode 14 and at least one of a third light emitting layer, a first light emitting layer and a second light emitting layer, since the light emitting device of the present embodiment is more excellent in light emission efficiency.

For example, when the light emitting device of the present embodiment has a third light emitting layer, the light emitting device of the present embodiment preferably further has at least one of a hole injection layer and a hole transporting layer between the anode 11 and the third light emitting layer, since the light emitting device of the present embodiment is more excellent in light emission efficiency. The light emitting device of the present embodiment preferably further has at least one of an electron injection layer and an electron transporting layer between the cathode 14 and the third light emitting layer, since the light emitting device of the present embodiment is more excellent in light emission efficiency.

For example, when the light emitting device of the present embodiment has a first light emitting layer, the light emitting device of the present embodiment preferably further has at least one of a hole injection layer and a hole transporting layer between the anode 11 and the first light emitting layer, since the light emitting device of the present embodiment is more excellent in light emission efficiency. The light emitting device of the present embodiment preferably further has at least one of an electron injection layer and an electron transporting layer between the cathode 14 and the first light emitting layer, since the light emitting device of the present embodiment is more excellent in light emission efficiency.

For example, when the light emitting device of the present embodiment has a second light emitting layer, the light emitting device of the present embodiment preferably further has at least one of a hole injection layer and a hole transporting layer between the anode 11 and the second light emitting layer, since the light emitting device of the present embodiment is more excellent in light emission efficiency. The light emitting device of the present embodiment preferably further has at least one of an electron injection layer and an electron transporting layer between the cathode 14 and the second light emitting layer, since the light emitting device of the present embodiment is more excellent in light emission efficiency.

For example, when the light emitting device of the present embodiment has a first light emitting layer and a second light emitting layer, the light emitting device of the present embodiment preferably further has at least one of a hole injection layer and a hole transporting layer between the anode 11 and the second light emitting layer, since the light emitting device of the present embodiment is more excellent in light emission efficiency. The light emitting device of the present embodiment preferably further has at least one of an electron injection layer and an electron transporting layer between the cathode 14 and the first light emitting layer, since the light emitting device of the present embodiment is more excellent in light emission efficiency.

The specific layer constitution of the light emitting device according to the present embodiment includes, for example, layer constitutions represented by (D1) to (D12). The light emitting device of the present embodiment usually has a substrate, and lamination may be performed on the substrate first from the anode, or may be performed on the substrate first from the cathode.

(D1) anode/hole injection layer/hole transporting layer (second layer)/third light emitting layer (third layer)/electron transporting layer (first layer)/electron injection layer/cathode
(D2) anode/hole injection layer (second layer)/hole transporting layer/third light emitting layer (third layer)/electron transporting layer (first layer)/electron injection layer/cathode
(D3) anode/hole injection layer/hole transporting layer (second layer)/third light emitting layer (third layer)/electron transporting layer/electron injection layer (first layer)/cathode
(D4) anode/hole injection layer/second light emitting layer (second layer)/third light emitting layer (third layer)/electron transporting layer (first layer)/electron injection layer/cathode
(D5) anode/hole injection layer/second light emitting layer (second layer)/third light emitting layer (third layer)/first light emitting layer (first layer)/electron transporting layer/electron injection layer/cathode (D6) anode/hole injection layer/hole transporting layer/second light emitting layer (second layer)/third light emitting layer (third layer)/electron transporting layer (first layer)/electron injection layer/cathode (D7) anode/hole injection layer/hole transporting layer/second light emitting layer (second layer)/electron transporting layer (first layer)/electron injection layer/cathode
(D8) anode/hole injection layer/hole transporting layer (second layer)/second light emitting layer/electron transporting layer (first layer)/electron injection layer/cathode
(D9) anode/hole injection layer/hole transporting layer (second layer)/first light emitting layer (first layer)/electron transporting layer/electron injection layer/cathode
(D10) anode/hole injection layer/second light emitting layer (second layer)/third light emitting layer (third layer)/first light emitting layer/electron transporting layer (first layer)/electron injection layer/cathode
(D11) anode/hole injection layer/hole transporting layer (second layer)/second light emitting layer/third light emitting layer (third layer)/first light emitting layer (first layer)/electron transporting layer/electron injection layer/cathode
(D12) anode/hole injection layer/hole transporting layer (second layer)/second light emitting layer/third light emitting layer (third layer)/first light emitting layer/electron transporting layer (first layer)/electron injection layer/cathode

In (D1) to (D12), "/" means that the layers before and after that are adjacently laminated. Specifically, "hole transporting layer (second layer)/third light emitting layer (third layer)/electron transporting layer (first layer)" means that the hole transporting layer (second layer) and the third light emitting layer (third layer) and the electron transporting layer (first layer) are laminated adjacently.

In the light emitting device of the present embodiment, two or more layers of each of the anode, the hole injection layer, the hole transporting layer, the third light emitting layer, the first light emitting layer, the second light emitting layer, the electron transporting layer, the electron injection layer and the cathode may be provided, if necessary.

When a plurality of the anodes, the hole injection layers, the hole transporting layers, the third light emitting layers, the first light emitting layers, the second light emitting layers, the electron transporting layers, the electron injection layers and the cathodes are present, they may be the same or different at each occurrence.

The thicknesses of the anode, the hole injection layer, the hole transporting layer, the third light emitting layer, the first light emitting layer, the electron transporting layer, the electron injection layer and the cathode are each usually 1 nm or more and 1 µm or less, preferably 2 nm or more and 500 nm or less, and further preferably 5 nm or more and 150 nm or less.

In the light emitting device of the present embodiment, the order, the number and the thickness of the layers to be laminated may be adjusted in consideration of the light emission efficiency, the driving voltage and the device life of the light emitting device.

### [First light emitting layer]

The first light emitting layer is usually a first layer or a layer containing a light emitting material, and preferably a layer containing a light emitting material. When the first light emitting layer is a layer containing a light emitting material, the light emitting material to be contained in the first light emitting layer includes, for example, the above-described light emitting materials which the composition 2 may contain. The light emitting material to be contained in the first light emitting layer may be contained singly or in combination of two or more.

When the light emitting device of the present embodiment has a first light emitting layer and the first layer is not an electron transporting layer described later and an electron injection layer described later, it is preferable that the first light emitting layer is the first layer.

### [Second light emitting layer]

The second light emitting layer is usually a second layer or a layer containing a light emitting material, and preferably a layer containing a light emitting material. When the second light emitting layer is a layer containing a light emitting material, the light emitting material to be contained in the second light emitting layer includes, for example, the above-described light emitting materials which the composition 2 may contain. The light emitting material to be contained in the second light emitting layer may be contained singly or in combination of two or more.

When the light emitting device of the present embodiment has a second light emitting layer and the second layer is not a hole transporting layer described later and a hole injection layer described later, it is preferable that the second light emitting layer is the second layer.

### [Hole transporting layer]

The hole transporting layer is usually a second layer or a layer containing a hole transporting material, and preferably a second layer. When the hole transporting layer is a layer containing a hole transporting material, the hole transporting material to be contained in the hole transporting layer includes, for example, the above-described hole transporting materials which the composition 2 may contain. The hole transporting material to be contained in the hole transporting layer may be contained singly or in combination of two or more.

When the light emitting device of the present embodiment has a hole transporting layer and the second layer is not a second light emitting layer described above and a hole injection layer described later, it is preferable that the hole transporting layer is the second layer.

### [Electron transporting layer]

The electron transporting layer is usually a first layer or a layer containing an electron transporting material, and preferably a first layer. When the electron transporting layer is a layer containing an electron transporting material, the electron transporting material to be contained in the electron transporting layer includes, for example, the above-described electron transporting materials which the composition 2 may contain. The electron transporting material to be contained in the electron transporting layer may be contained singly or in combination of two or more.

When the light emitting device of the present embodiment has an electron transporting layer and the first layer is not a first light emitting layer described above and an electron injection layer described later, it is preferable that the electron transporting layer is the first layer.

### [Hole injection layer and electron injection layer]

The hole injection layer is a second layer or a layer containing a hole injection material, and preferably a layer containing a hole injection material. The hole injection material to be contained in a hole injection layer includes, for example, the above-described hole injection materials which the composition 2 may contain. The hole injection material to be contained in the hole injection layer may be contained singly or in combination of two or more.

When the light emitting device of the present embodiment has a hole injection layer and the second layer is not a second light emitting layer described above and a hole transporting layer described above, it is preferable that the hole injection layer is the second layer.

The electron injection layer is a first layer or a layer containing an electron injection material, and preferably a layer containing an electron injection material. When the electron injection layer is a layer containing an electron injection material, the electron injection material to be contained in an electron injection layer includes, for example, the above-described electron injection materials which the composition 2 may contain. The electron injection material to be contained in the electron injection layer may be contained singly or in combination of two or more.

When the light emitting device of the present embodiment has an electron injection layer and the first layer is not a first light emitting layer described above and an electron transporting layer described above, it is preferable that the electron injection layer is the first layer.

### [Substrate/electrode]

The substrate in the light emitting device may be a substrate that can form an electrode and does not chemically change when forming a layer, and may be a substrate made of a material such as, for example, glass, plastic, silicon and the like. When an opaque substrate is used, it is preferable that the electrode farthest from the substrate is transparent or semitransparent.

The material for the anode includes, for example, conductive metal oxides and semitransparent metals, preferably, indium oxide, zinc oxide, tin oxide; conductive compounds such as indium•tin•oxide (ITO), indium•zinc•oxide, and the like; a complex of argentine, palladium and copper (APC); NESA, gold, platinum, silver, and copper.

The material of the cathode includes, for example, metals such as lithium, sodium, potassium, rubidium, cesium, beryllium, magnesium, calcium, strontium, barium, aluminum, zinc, indium and the like; alloys composed of two or more metals described above; alloys composed of one or more metals described above and one or more metals selected from the group consisting of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

In the light emitting device of the present embodiment, at least one of the anode and the cathode is usually transparent or semitransparent, but it is preferable that the anode is transparent or semitransparent.

The method for forming the anode and the cathode includes, for example, a vacuum vapor deposition method, a sputtering method, an ion plating method, a plating method and a laminating method.

### [Production method of light emitting device]

The methods for forming the first layer, the second layer, the third layer and other layers in the light emitting device of the present embodiment include, for example, dry methods such as a vacuum vapor deposition method and the like and the wet methods described in the section of the ink 2, when a low-molecular compound is used, and include, for example, the wet methods described in the section of the ink 2, when a polymer compound is used. The first layer, the second layer, the third layer and other layers may be formed by the wet method described in the section of the ink 2 or may be formed by a dry method such as a vacuum vapor deposition method and the like, using the above-described various inks or inks containing the various materials.

When the first layer is formed by a wet method, it is preferable to use the ink 1. The first layer is preferably formed by a wet method, since production of the light emitting device of the present embodiment is easy. For example, when the first layer is laminated on the second layer (or third layer) utilizing the difference in solubility from the second layer (or third layer), it becomes easy to laminate the first layer by using a solution having low solubility in the second layer (or third layer).

When the second layer is formed by a wet method, it is preferable to use the ink 2. The second layer is preferably formed by a wet method, since production of the light emitting device of the present embodiment is easy.

After formation of the second layer, the compound having a crosslinkable group selected from Group A of crosslinkable group contained in the second layer can be crosslinked by heating or light irradiation. After forming the second layer, the compound having a crosslinkable group selected from Group A of crosslinkable group contained in the second layer is preferably crosslinked by heating. Since the second layer is contained in the state where the compound having a crosslinkable group selected from Group A of crosslinkable group is crosslinked (a crosslinked product of the compound having a crosslinkable group selected from Group A of crosslinkable group), the second layer is substantially insolubilized in a solvent. Hence, the second layer can be suitably used for lamination of a light emitting device.

The heating temperature for crosslinking is usually 25°C to 300°C, preferably 50°C to 260°C, more preferably 130°C to 230°C, and further preferably 180°C to 210°C.

The heating time is usually 0.1 minutes to 1000 minutes, preferably 0.5 minutes to 500 minutes, more preferably 1 minute to 120 minutes, and further preferably 10 minutes to 60 minutes.

The type of the light used for irradiation is, for example, ultraviolet ray, near-ultraviolet ray or visible light.

When the third layer is formed by a wet method, it is preferable to use the ink 3. The third layer is preferably formed by a wet method, since production of the light emitting device of the present embodiment is easy.

The light emitting device of the present embodiment can be produced, for example, by sequentially laminating each layer on substrate. Specifically, a light emitting device can be produced by providing an anode on a substrate, providing layers of a hole injection layer, a hole transporting layer and the like on this, providing a light emitting layer on this, providing layers of an electron transporting layer, an electron injection layer and the like on this, and further laminating a cathode on this. As other production methods, a light emitting device can be produced by providing a cathode on a substrate, providing layers of an electron injection layer, an electron transporting layer, a light emitting layer, a hole transporting layer, a hole injection layer and the like on this, and further laminating an anode on this. As further other production methods, a light emitting device can be produced by joining an anode or an anode-side substrate on which each layer is laminated on an anode and a cathode or a cathode-side substrate on which each layer is laminated on a cathode so as to face each other.

In fabrication of the light emitting device of the present embodiment, when the material used for forming a hole injection layer, the material used for forming a light emitting layer, the material used for forming a hole transporting layer, the material used for forming an electron transporting layer and the material used for forming an electron injection layer are each soluble in solvents used in forming layers adjacent to the hole injection layer, the light emitting layer, the hole transporting layer, the electron transporting layer and the electron injection layer, it is preferable to prevent the materials from dissolving in the solvents. The method for preventing dissolution of the material is preferably i) a method using a material having a crosslinkable group or ii) a method of making a difference in the solubility of adjacent layers in a solvent. In the above-described method i), after forming a layer using the material having a crosslinkable group, the layer can be insolubilized by crosslinking the crosslinkable group. Further, in the above-described method ii), for example, when an electron transporting layer is laminated on a light emitting layer by utilizing a difference in solubility, the electron transporting layer can be laminated on the light emitting layer by using an ink having low solubility for the light emitting layer.

### [Application of light emitting device]

In order to obtain planar light emission using a light emitting device, a planar anode and a planar cathode may be arranged so that they overlap with each other. In order to obtain a patterned light emission, there are a method of providing a mask with a patterned window on the surface of a planar light emitting device, a method of forming a layer to be a non-light emitting portion with an extremely large thickness to make it substantially non-luminescent, and a method of forming an anode or a cathode, or both electrodes in a pattern. By forming a pattern by any of the above-mentioned methods and arranging some electrodes so that they can be turned ON/OFF independently, a segment type display device capable of displaying numbers, characters and the like can be obtained. In order to obtain a dot matrix display device, both the anode and the cathode may be formed in stripes and arranged so as to be orthogonal to each other. Partial color display and multi-color display become possible by a method of separately coating a plurality of types of polymer compounds having different emission colors or a method of using a color filter or a fluorescence conversion filter. The dot matrix display device can be passively driven or can be actively driven in combination with TFT or the like. These display devices can be used for displays of computers, televisions, mobile terminals and the like. The planar light emitting device can be suitably used as a planar light source for a backlight of a liquid crystal display device or a planar light source for illumination. If a flexible substrate is used, it can be used also as a curved light source and a curved display device.

### EXAMPLES

The present invention will be illustrated further in detail with reference to examples below, but the present invention is not limited to these examples.

In examples, the polystyrene-equivalent number-average molecular weight (Mn) and the polystyrene-equivalent weight-average molecular weight (Mw) of polymer compounds were determined by size exclusion chromatography (SEC) using tetrahydrofuran as the mobile phase. The measurement conditions of SEC are as follows.

The polymer compound to be measured was dissolved at a concentration of about 0.05% by mass in tetrahydrofuran, and 10 µL of the solution was injected into SEC. The mobile phase was flowed at a flow rate of 2.0 mL/min. As the column, PLgel MIXED-B (manufactured by Polymer Laboratories Ltd.) was used. As the detector, UV-VIS Detector (manufactured by Shimadzu Corporation, trade name: SPD-10Avp) was used.

LC-MS was measured by the following method.

The measurement sample was dissolved in tetrahydrofuran to a concentration of about 2 mg/mL, and about 1 µL of the solution was injected into LC-MS (manufactured by Agilent Technologies Japan, Ltd., trade name: 1290 Infinity LC and 6230 TOF LC/MS). As the mobile phase for LC-MS, acetonitrile and tetrahydrofuran were flowed at a flow rate of 1.0 mL/min while changing the ratio of acetonitrile/tetrahydrofuran. As the column, SUMIPAX ODS Z-CLUE (manufactured by Sumika Chemical Analysis Service, Ltd., internal diameter: 4.6 mm, length: 250 mm, particle diameter: 3 µm) was used.

NMR was measured by the following method.

Five to ten milligrams (5 to 10 mg) of the measurement sample was dissolved in about 0.5 mL of heavy tetrahydrofuran, and NMR thereof was measured using an NMR apparatus (manufactured by JEOL RESONANCE Inc., trade name: JNM-ECZ400S/L1).

As the indicator for the purity of a compound, the value of the area percentage of high performance liquid chromatography (HPLC) was used. This value is a value at UV = 254 nm by HPLC (manufactured by Shimadzu Corp., trade name: LC-20A), unless otherwise stated. In this procedure, the compound to be measured was dissolved in tetrahydrofuran to a concentration of 0.01 to 0.2% by mass, and the solution was injected into HPLC in an amount of 1 to 10 µL depending on the concentration. As the mobile phase of HPLC, acetonitrile and tetrahydrofuran were flowed at a flow rate of 1.0 mL/min while changing the ratio of acetonitrile/tetrahydrofuran from 100/0 to 0/100 (volume ratio). As the column, SUMIPAX ODS Z-CLUE (manufactured by Sumika Chemical Analysis Service, Ltd., internal diameter: 4.6 mm, length: 250 mm, particle diameter: 3 µm) was used. As the detector, Photodiode Array Detector (manufactured by Shimadzu Corp., trade name: SPD-M20A) was used.

### <Synthesis Example M> Synthesis of compounds M1 to M11

A compound M1 was synthesized according to a method described in International Publication WO2015/145871.

A compound M2 was synthesized according to a method described in International Publication WO2013/146806.

A compound M3 was synthesized according to a method described in International Publication WO2005/049546.

A compound M4 was synthesized according to a method described in Unexamined Patent Application Publication (JP-A) No. 2010-189630.

A compound M5, a compound M6 and a compound M9 were synthesized with reference to a method described in International Publication WO2002/045184.

A compound M7 was synthesized according to a method described in International Publication WO2011/049241.

A compound M8 was synthesized according to a method described in JP-A No. 2011-174062.

A compound M10 was synthesized according to a method described in JP-A No. 2008-106241.

A compound M11 was synthesized according to a method described in JP-A No. 2010-215886.

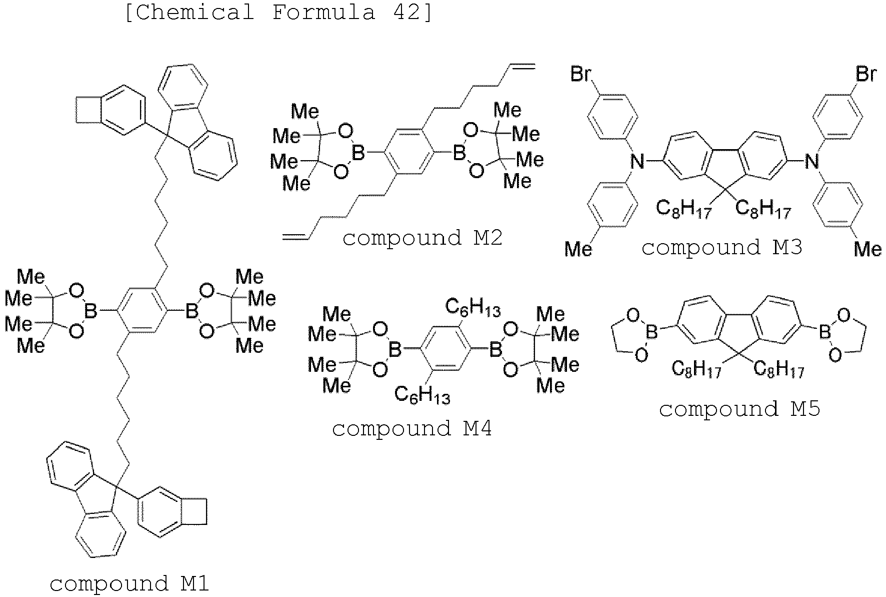

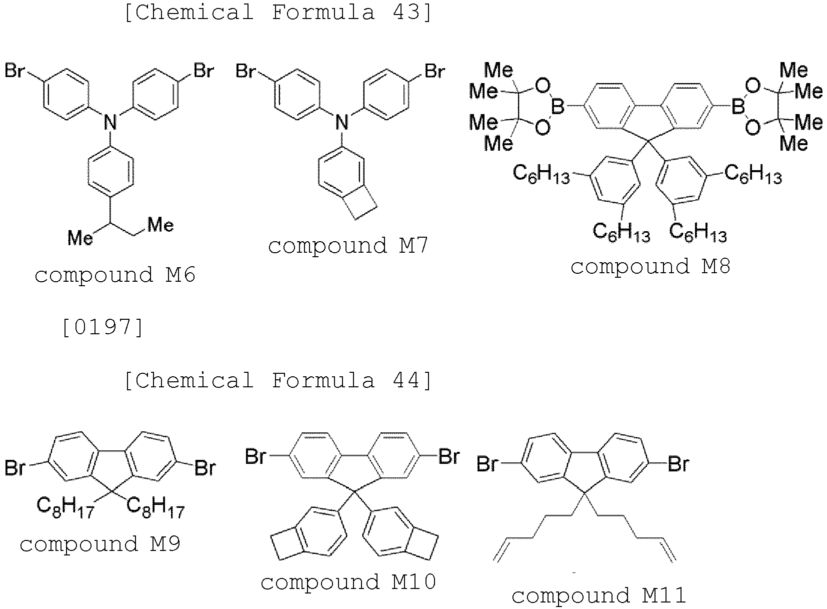

### <Synthesis Example HTL-1> Synthesis of polymer compound HTL-1

A polymer compound HTL-1 was synthesized according to a method described in International Publication WO2015/145871 using the compound M1, the compound M2 and the compound M3. The polymer compound HTL-1 had an Mn of 2.3×10⁴ and an Mw of 1.2×10⁵.

The polymer compound HTL-1 is a copolymer constituted of a constitutional unit derived from the compound M1, a constitutional unit derived from the compound M2 and a constitutional unit derived from the compound M3 at a molar ratio of 45:5:50, according to the theoretical values calculated from the amounts of charging raw materials.

### <Synthesis Example HTL-2> Synthesis of polymer compound HTL-2

A polymer compound HTL-2 was synthesized according to a method described in International Publication WO2011/049241 using the compound M5, the compound M6 and the compound M7. The polymer compound HTL-2 had an Mn of 8.9×10⁴ and an Mw of 4.2×10⁵.

The polymer compound HTL-2 is a copolymer constituted of a constitutional unit derived from the compound M5, a constitutional unit derived from the compound M6 and a constitutional unit derived from the compound M7 at a molar ratio of 50:42.5:7.5, according to the theoretical values calculated from the amounts of charging raw materials.

### <Synthesis Example HTL-3> Synthesis of polymer compound HTL-3

A polymer compound HTL-3 was synthesized according to a method described in JP-A No. 2012-144722 using the compound M8, the compound M3, the compound M9 and the compound M10. The polymer compound HTL-3 had an Mn of 7.8×10⁴ and an Mw of 2.6×10⁵.

The polymer compound HTL-3 is a copolymer constituted of a constitutional unit derived from the compound M8, a constitutional unit derived from the compound M3, a constitutional unit derived from the compound M9 and a constitutional unit derived from the compound M10 at a molar ratio of 50:30:12.5:7.5, according to the theoretical values calculated from the amounts of charging raw materials.

### <Synthesis Example HTL-C1> Synthesis of polymer compound HTL-C1

A polymer compound HTL-C1 was synthesized according to a method described in International Publication WO2015/194448 using the compound M4 and the compound M3. The polymer compound HTL-C1 had an Mn of 4.5×10⁴ and an Mw of 1.5×10⁵.

The polymer compound HTL-C1 is a copolymer constituted of a constitutional unit derived from the compound M4 and a constitutional unit derived from the compound M3 at a molar ratio of 50:50, according to the theoretical values calculated from the amounts of charging raw materials.

### <Synthesis Example HTL-C2> Synthesis of polymer compound HTL-C2

A polymer compound HTL-C2 was synthesized according to a method described in JP-A No. 2012-36381 using the compound M5 and the compound M6. The polymer compound HTL-C2 had an Mn of 8.1×10⁴ and an Mw of 3.4×10⁵.

The polymer compound HTL-C2 is a copolymer constituted of a constitutional unit derived from the compound M5 and a constitutional unit derived from the compound M6 at a molar ratio of 50:50, according to the theoretical values calculated from the amounts of charging raw materials.

### <Synthesis Example HTL-C3> Synthesis of polymer compound HTL-C3

A polymer compound HTL-C3 was synthesized with reference to a method described in JP-A No. 2012-144722 using the compound M8, the compound M3, the compound M9 and the compound M11. The polymer compound HTL-C3 had an Mn of 5.0×10⁴ and an Mw of 2.5×10⁵.

The polymer compound HTL-C3 is a copolymer constituted of a constitutional unit derived from the compound M8, a constitutional unit derived from the compound M3, a constitutional unit derived from the compound M9 and a constitutional unit derived from the compound M11 at a molar ratio of 50:30:12.5:7.5, according to the theoretical values calculated from the amounts of charging raw materials.

### <Compound HM-1 and compound HTM-1>

A compound HM-1 and a compound HTM-1 were purchased from Luminescence Technology Corp.

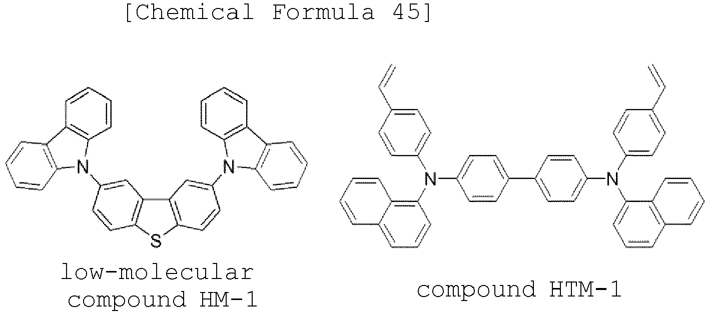

### <Metal complex B1, metal complex R1 and compound ET1>

A metal complex B1 was synthesized with reference to a method described in International Publication WO2006/121811 and JP-A No. 2013-048190.

A metal complex R1 was purchased from American Dye Source, Inc.

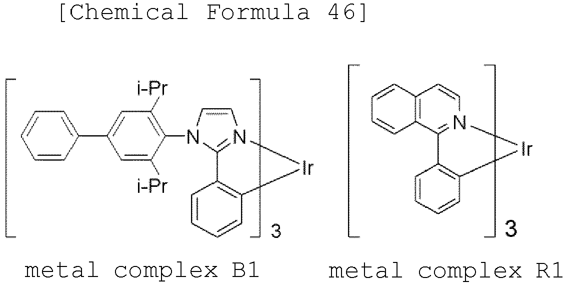

### <Synthesis Example ET1> Synthesis of compound ET1 and compound ET3

A compound ET1 and a compound ET3 were synthesized with reference to a method described in JP-A No. 2010-235575.

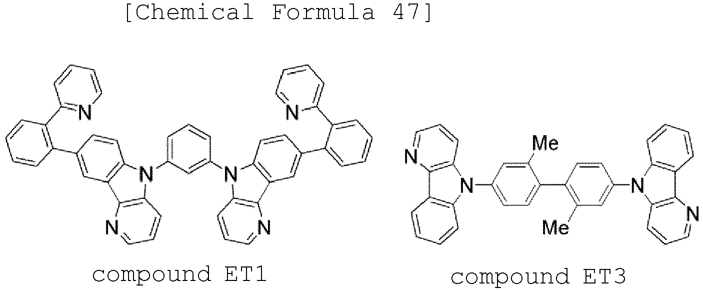

### <Compound ET2> Synthesis of compound ET2

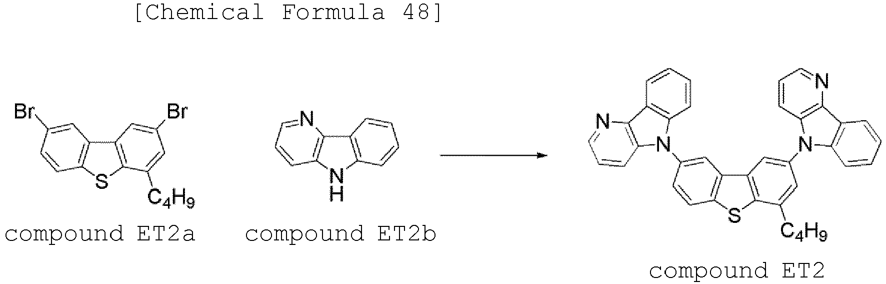

An inert gas atmosphere was prepared in a reaction vessel, then, the compound ET2a (8.7 g), the compound ET2b (8.1 g), dimethyl sulfoxide (218 mL), copper(I) oxide (1.3 g), tripotassium phosphate (16.7 g) and dipivaloylmethane (3.2 g) were added, and the mixture was stirred at 150°C for 10 hours. The resultant reaction liquid was cooled down to room temperature, then, toluene and ion-exchanged water were added, and the mixture was filtrated through a glass filter paved with Celite. The resultant filtrate was washed with ion-exchanged water, then, the resultant organic layer was concentrated, to obtain a coarse product. The resultant coarse product was purified by silica gel column chromatography (mixed solvent of hexane and ethyl acetate), then, crystallized using a mixed solvent of acetonitrile and toluene. The resultant solid was dried under reduced pressure at 50°C, to obtain a compound ET2 (8.0 g). The HPLC area percentage value of the compound ET2 was 99.5% or more.

The analysis results of the compound ET2 are as follows.

LC-MS (ESI, positive): m/z = 573 [M+H]⁺

¹H-NMR (400 MHz, THF-ds): δ (ppm) = 1.01 (t,3H), 1.58-1.68 (m,2H), 1.95-2.05 (m,2H), 3.14-3.19 (m,2H), 7.32-7.39 (m,4H), 7.49-7.57 (m,4H), 7.72 (s, 1H), 7.79-7.88 (m,3H), 8.34-8.42 (m,3H), 8.55-8.68 (m,4H).

### <Example D1> Fabrication and evaluation of light emitting devices D1

### (Formation of anode and hole injection layer)

An ITO film was attached with a thickness of 45 nm to a glass substrate by a sputtering method, to form an anode. A hole injection material ND-3202 (manufactured by Nissan Chemical Corporation) was spin-coated on the anode, to form a film with a thickness of 35 nm. Under an air atmosphere, the film was heated on a hot plate at 50°C for 3 minutes, and further, heated at 230°C for 15 minutes, to form a hole injection layer.

### (Formation of second layer)

The polymer compound HTL-3 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere, to form a second layer (hole transporting layer). By this heating, the polymer compound HTL-3 became a crosslinked product.

### (Formation of third layer)

The compound HM-1 and the metal complex B1 (compound HM-1/metal complex B1 = 75% by mass/25% by mass) were dissolved at a concentration of 2% by mass in toluene. The resultant toluene solution was spin-coated on the second layer to form a film with a thickness of 80 nm, and the film was heated at 130°C for 10 minutes under a nitrogen gas atmosphere, to form a third layer (light emitting layer).

### (Formation of first layer)

The compound ET1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the third layer to form a film with a thickness of 10 nm, and the film was heated at 130°C for 10 minutes under a nitrogen gas atmosphere, to form a first layer (electron transporting layer).

### (Formation of cathode)

The substrate carrying the first layer formed thereon was placed in a vapor deposition machine and the internal pressure thereof was reduced to 1.0×10⁻⁴ Pa or less, then, sodium fluoride was vapor-deposited with a thickness of about 4 nm on the first layer, then, aluminum was vapor-deposited with a thickness of about 80 nm on the sodium fluoride layer, as cathodes. After vapor deposition, sealing was performed using a glass substrate, to fabricate a light emitting device D1.

### (Evaluation of light emitting device)

Voltage was applied to the light emitting device D1, to observe EL emission. The light emission efficiency [cd/A] and the CIE chromaticity coordinate (x,y) at 0.1 mA/cm² were measured. The CIE chromaticity coordinate (x,y) is xy chromaticity coordinate (x,y) based on the XYZ color system which is an international display method formulated in 1931 by International Illumination Commission (CIE: Commission Internationale de l'Eclairage).

### <Example D2 and Comparative Example CD1 to CD2>

Fabrication and evaluation of light emitting devices D2, CD1 and CD2

Light emitting devices D2, CD1 and CD2 were fabricated in the same manner as in Example D1, except that materials described in Table 2 were used instead of "the polymer compound HTL-3" in (Formation of second layer) of Example D1.

Voltage was applied to the light emitting devices D2, CD1 and CD2, to observe EL emission. The light emission efficiency [cd/A] and the CIE chromaticity coordinate (x,y) at 0.1 mA/cm² were measured.

The results of Example D1 to D2 and Comparative Example CD1 to CD2 are shown in Table 2. The relative values of the light emission efficiency of the light emitting devices D1, D2 and CD2 when the light emission efficiency of the light emitting device CD1 is taken as 1.0 is shown.

**[Table 2]**

| | Light emitting device | Second layer | Third layer | | First layer | Light emission efficiency (relative value) | CIE chromaticity coordinate (x, y) |
|---|---|---|---|---|---|---|---|
| | | material | material | Composition ratio (% by mass) | material | | |
| Example D1 | D1 | HTL-3 | HM-1/B1 | 75/25 | ET1 | 1.9 | (0.21, 0.44) |
| Comparative Example CD1 | CD1 | HTL-C3 | HM-1/B1 | 75/25 | ET1 | 1.0 | (0.17, 0.41) |
| Example D2 | D2 | HTL-2 | HM-1/B1 | 75/25 | ET1 | 1.3 | (0.22, 0.41) |
| Comparative Example CD2 | CD2 | HTL-C2 | HM-1/B1 | 75/25 | ET1 | 0.3 | (0.22, 0.45) |

### <Example D3 and Comparative Example CD3> Fabrication and evaluation of light emitting devices D3 and CD3

Light emitting devices D3 and CD3 were fabricated in the same manner as in Example D1, except that materials described in Table 3 were used instead of "the compound ET1" in (Formation of first layer) of Example D1, and further, materials described in Table 3 were used instead of "the polymer compound HTL-3" in (Formation of second layer) of Example D1.

Voltage was applied to the light emitting devices D3 and CD3, to observe EL emission. The light emission efficiency [cd/A] and the CIE chromaticity coordinate (x,y) at 3 mA/cm² were measured.

The results of Example D3 and Comparative Example CD3 are shown in Table 3. The relative value of the light emission efficiency of the light emitting device D3 when the light emission efficiency of the light emitting device CD3 is taken as 1.0 is shown.

**[Table 3]**

| | Light emitting device | Second layer | Third layer | | First layer | Light emission efficiency (relative value) | CIE chromaticity coordinate (x, y) |
|---|---|---|---|---|---|---|---|
| | | material | material | Composition ratio (% by mass) | material | | |
| Example D3 | D3 | HTL-3 | HM-1/B1 | 75/25 | ET2 | 4.5 | (0.19, 0.43) |
| Comparative Example CD3 | CD3 | HTL-C3 | HM-1/B1 | 75/25 | ET2 | 1.0 | (0.19, 0.43) |

### <Example D4 and Comparative Example CD4> Fabrication and evaluation of light emitting devices D4 and CD4

Light emitting devices D4 and CD4 were fabricated in the same manner as in Example D1, except that a material described in Table 4 was used instead of "the compound ET1" in (Formation of first layer) of Example D1, and materials described in Table 4 were used instead of "the polymer compound HTL-3" in (Formation of second layer) of Example D1.

Voltage was applied to the light emitting devices D4 and CD4, to observe EL emission. The light emission efficiency [cd/A] and the CIE chromaticity coordinate (x,y) at 2 mA/cm² were measured.

The results of Example D4 and Comparative Example CD4 are shown in Table 4. The relative value of the light emission efficiency of the light emitting device D4 when the light emission efficiency of the light emitting device CD4 is taken as 1.0 is shown.

**[Table 4]**

| | Light emitting device | Second layer | Third layer | | First layer | Light emission efficiency (relative value) | CIE chromaticity coordinate (x, y) |
|---|---|---|---|---|---|---|---|
| | | material | material | Composition ratio (% by mass) | material | | |
| Example D4 | D4 | HTL-3 | HM-1/B1 | 75/25 | ET3 | 4.7 | (0.19, 0.42) |
| Comparative Example CD4 | CD4 | HTL-C3 | HM-1/B1 | 75/23 | ET3 | 1.0 | (0.19, 0.43) |

### <Example D5 and Comparative Example CD5> Fabrication and evaluation of light emitting devices D5 and CD5

The light emitting devices D5 and CD5 were fabricated in the same manner as in Example D1, except that materials described in Table 5 were used instead of "the polymer compound HTL-3" in (Formation of second layer) of Example D1.

Voltage was applied to the light emitting devices D5 and CD5, to observe EL emission. The light emission efficiency [cd/A] and the CIE chromaticity coordinate (x,y) at 1 mA/cm² were measured.

The results of Example D5 and Comparative Example CD5 are shown in Table 5. The relative value of the light emission efficiency of the light emitting device D5 when the light emission efficiency of the light emitting device CD5 is taken as 1.0 is shown.

**[Table 5]**

| | Light emitting device | Second layer | Third layer | | First layer | Light emission efficiency (relative value) | CIE chromaticity coordinate (x, y) |
|---|---|---|---|---|---|---|---|
| | | material | material | Composition ratio (% by mass) | material | | |
| Example D5 | D5 | HTL-1 | HM-1/B1 | 75/25 | ET1 | 1.7 | (0.18, 0.41) |
| Comparative Example CD5 | CD5 | HTL-C1 | HM-1/B1 | 75/25 | ET1 | 1.0 | (0.18, 0.42) |

### <Example D6 and Comparative Example CD6> Fabrication and evaluation of light emitting devices D6 and CD6

Light emitting devices D6 and CD6 were fabricated in the same manner as in Example D1, except that materials described in Table 5 were used instead of "the polymer compound HTL-3" in (Formation of second layer) of Example D1 and materials described in Table 6 were used instead of "the compound HM-1 and the metal complex B1" in (Formation of third layer) of Example D1.

Voltage was applied to the light emitting devices D6 and CD6, to observe EL emission. The light emission efficiency [cd/A] and the CIE chromaticity coordinate (x,y) at 0.02 mA/cm² were measured.

The results of Example D6 and Comparative Example CD6 are shown in Table 6. The relative value of the light emission efficiency of the light emitting device D6 when the light emission efficiency of the light emitting device CD6 is taken as 1.0 is shown.

**[Table 6]**

| | Light emitting device | Second layer | Third layer | | First layer | Light emission efficiency (relative value) | CIE chromaticity coordinate (x, y) |
|---|---|---|---|---|---|---|---|
| | | material | material | Composition ratio (% by mass) | material | | |
| Example D6 | D6 | HTL-1 | HM-1/B1/R1 | 74/25/1 | ET1 | 1.6 | (0.31, 0.36) |
| Comparative Example CD6 | CD6 | HTL-C1 | HM-1/B1/R1 | 74/25/1 | ET1 | 1.0 | (0.29, 0.34) |

### Industrial Applicability

According to the present invention, a light emitting device excellent in light emission efficiency can be provided.

### Description of reference numeral

- 10:: light emitting device
- 11:: anode
- 12:: second layer
- 13:: first layer
- 14:: cathode

## Claims

1. A light emitting device having an anode, a cathode, a first layer disposed between said anode and said cathode, and a second layer disposed between said anode and said first layer, wherein
said second layer is a layer containing a crosslinked product of a compound having a crosslinkable group selected from Group A of crosslinkable group, and
at least one of said first layer and said second layer contains a compound represented by the formula (T-1):
(Group A of crosslinkable group) 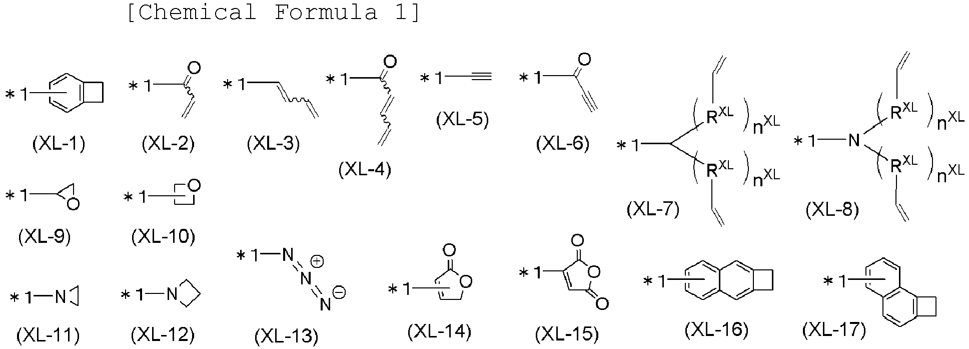 wherein, R^{XL} represents a methylene group, an oxygen atom or a sulfur atom, n^{XL} represents an integer of 0 to 5, when a plurality of R^{XL} are present, they may be the same or different, when a plurality of n^{XL} are present, they may be the same or different, *1 represents a binding position, and these crosslinkable groups optionally have a single or a plurality of substituents, and when a plurality of the substituents are present, they may be the same or different and may be combined together to form a ring together with carbon atoms to which they are attached, 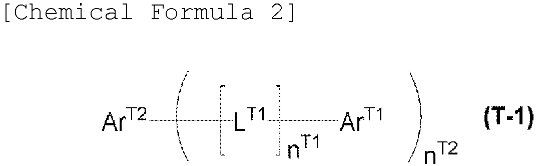 wherein,
n^{T1} represents an integer of 0 or more and 5 or less, when a plurality of n^{T1} are present, they may be the same or different,
n^{T2} represents an integer of 1 or more and 10 or less,
Ar^{T1} is a condensed monovalent hetero ring group containing a nitrogen atom having no double bond and a group represented by =N- in the ring, and the group optionally has a single or a plurality of substituents, and when a plurality of said substituents are present, they may be the same or different and may be combined together to form a ring together with atoms to which they are attached, when a plurality of Ar^{T1} are present, they may be the same or different,
L^{T1} represents an alkylene group, a cycloalkylene group, an arylene group, a divalent hetero ring group, a group represented by -NR^{T1}'-, an oxygen atom or a sulfur atom, and these groups optionally have a single or a plurality of substituents, and when a plurality of said substituents are present, they may be the same or different and may be combined together to form a ring together with atoms to which they are attached, R^{T1}' represents a hydrogen atom, an alkyl group, a cycloalkyl group, an aryl group or a monovalent hetero ring group, and these groups optionally have a single or a plurality of substituents, and when a plurality of said substituents are present, they may be the same or different and may be combined together to form a ring together with atoms to which they are attached, when a plurality of L^{T1} are present, they may be the same or different,
Ar^{T2} represents an aromatic hydrocarbon group or a hetero ring group, and these groups optionally have a single or a plurality of substituents, and when a plurality of said substituents are present, they may be the same or different and may be combined together to form a ring together with atoms to which they are attached.

2. The light emitting device according to Claim 1, wherein
the compound having a crosslinkable group selected from Group A of crosslinkable group described above is a polymer compound having a crosslinkable group selected from Group A of crosslinkable group described above.

3. The light emitting device according to Claim 2, wherein
said polymer compound is a polymer compound containing a crosslinkable group selected from Group A of crosslinkable group described above as a crosslinkable constitutional unit having a crosslinkable group selected from Group A of crosslinkable group described above, and
said crosslinkable constitutional unit is a constitutional unit represented by the formula (Z) or the formula (Z'): 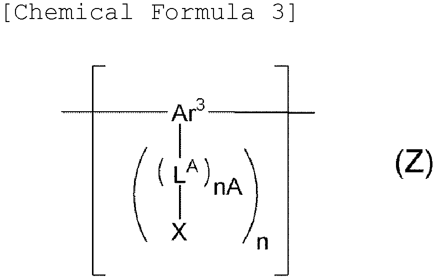 wherein,
n represents an integer of 1 or more,
nA represents an integer of 0 or more, when a plurality of nA are present, they may be the same or different,
Ar³ represents an aromatic hydrocarbon group, a hetero ring group, or a group in which at least one aromatic hydrocarbon group and at least one hetero ring group are bonded directly, and these groups optionally have a single or a plurality of substituents, when a plurality of said substituents are present, they may be the same or different and may be combined together to form a ring together with atoms to which they are attached,
L^{A} represents an alkylene group, a cycloalkylene group, an arylene group, a divalent hetero ring group, a group represented by -N(R')-, an oxygen atom or a sulfur atom, and these groups optionally have a single or a plurality of substituents, when a plurality of said substituents are present, they may be the same or different and may be combined together to form a ring together with atoms to which they are attached, R' represents a hydrogen atom, an alkyl group, a cycloalkyl group, an aryl group or a monovalent hetero ring group, and these groups optionally have a single or a plurality of substituents, when a plurality of said substituents are present, they may be the same or different and may be combined together to form a ring together with atoms to which they are attached, when a plurality of L^{A} are present, they may be the same or different,
X represents a crosslinkable group selected from Group A of crosslinkable group described above, when a plurality of X are present, they may be the same or different, 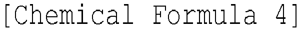 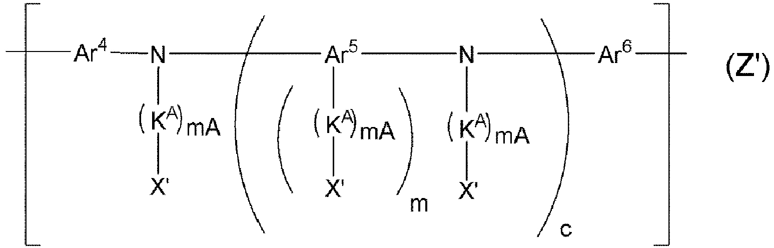
wherein,
mA, m and c each independently represent an integer of 0 or more, when a plurality of mA are present, they may be the same or different, when a plurality of m are present, they may be the same or different,
Ar⁵ represents an aromatic hydrocarbon group, a hetero ring group, or a group in which at least one aromatic hydrocarbon group and at least one hetero ring group are bonded directly, and these groups optionally have a single or a plurality of substituents, when a plurality of said substituents are present, they may be the same or different and may be combined together to form a ring together with atoms to which they are attached, when a plurality of Ar⁵ are present, they may be the same or different,
Ar⁴ and Ar⁶ each independently represent an arylene group or a divalent hetero ring group, and these groups optionally have a single or a plurality of substituents, when a plurality of said substituents are present, they may be the same or different and may be combined together to form a ring together with atoms to which they are attached,
K^{A} represents an alkylene group, a cycloalkylene group, an arylene group, a divalent hetero ring group, a group represented by -N(R")-, an oxygen atom or a sulfur atom, and these groups optionally have a single or a plurality of substituents, when a plurality of said substituents are present, they may be the same or different and may be combined together to form a ring together with atoms to which they are attached, R" represents a hydrogen atom, an alkyl group, a cycloalkyl group, an aryl group or a monovalent hetero ring group, and these groups optionally have a single or a plurality of substituents, when a plurality of said substituents are present, they may be the same or different and may be combined together to form a ring together with atoms to which they are attached, when a plurality of K^{A} are present, they may be the same or different,
X' represents a crosslinkable group selected from Group A of crosslinkable group described above, a hydrogen atom, an alkyl group, a cycloalkyl group, an aryl group or a monovalent hetero ring group, and these groups optionally have a single or a plurality of substituents, when a plurality of said substituents are present, they may be the same or different and may be combined together to form a ring together with atoms to which they are attached, when a plurality of X' are present, they may be the same or different, however, at least one X' is a crosslinkable group selected from Group A of crosslinkable group described above.

4. The light emitting device according to Claim 1, wherein
the compound having a crosslinkable group selected from Group A of crosslinkable group described above is a low-molecular compound represented by the formula (Z"): 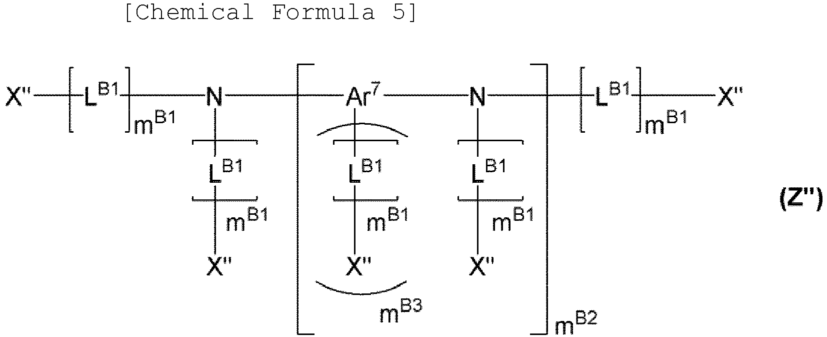 wherein,
m^{B1}, m^{B2} and m^{B3} each independently represent an integer of 0 or more and 10 or less, a plurality of m^{B1} may be the same or different, when a plurality of m^{B3} are present, they may be the same or different,
Ar⁷ represents an aromatic hydrocarbon group, a hetero ring group, or a group in which at least one aromatic hydrocarbon group and at least one hetero ring group are bonded directly, and these groups optionally have a single or a plurality of substituents, when a plurality of said substituents are present, they may be the same or different and may be combined together to form a ring together with atoms to which they are attached, when a plurality of Ar⁷ are present, they may be the same or different,
L^{B1} represents an alkylene group, a cycloalkylene group, an arylene group, a divalent hetero ring group, a group represented by -N(R''')-, an oxygen atom or a sulfur atom, and these groups optionally have a single or a plurality of substituents, when a plurality of said substituents are present, they may be the same or different and may be combined together to form a ring together with atoms to which they are attached, R''' represents a hydrogen atom, an alkyl group, a cycloalkyl group, an aryl group or a monovalent hetero ring group, and these groups optionally have a single or a plurality of substituents, when a plurality of said substituents are present, they may be the same or different and may be combined together to form a ring together with atoms to which they are attached, when a plurality of L^{B1} are present, they may be the same or different, X'' represents a crosslinkable group selected from Group A of crosslinkable group described above, a hydrogen atom, an alkyl group, a cycloalkyl group, an aryl group or a monovalent hetero ring group, and these groups optionally have a single or a plurality of substituents, when a plurality of said substituents are present, they may be the same or different and may be combined together to form a ring together with atoms to which they are attached, a plurality of X'' may be the same or different, however, at least one of a plurality of X'' is a crosslinkable group selected from Group A of crosslinkable group described above.

5. The light emitting device according to any one of Claims 1 to 4, wherein
the crosslinkable group selected from Group A of crosslinkable group described above is a group represented by said formula (XL-1), said formula (XL-16) or said formula (XL-17).

6. The light emitting device according to any one of Claims 1 to 5, wherein
said first layer contains a compound represented by said formula (T-1).

7. The light emitting device according to any one of Claims 1 to 6, wherein
said Ar^{T1} is a group represented by the formula (T1-1) : 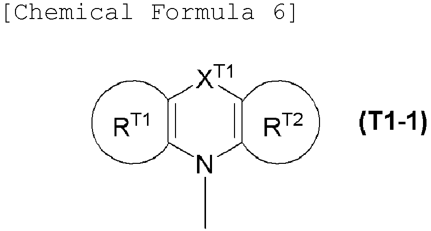 wherein,
X^{T1} represents a single bond, an oxygen atom, a sulfur atom, a group represented by -N(R^{XT1})-, or a group represented by -C(R^{XT1}')₂-; R^{XT1} and R^{XT1}' each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally have a single or a plurality of substituents, and when a plurality of said substituents are present, they may be the same or different and may be combined together to form a ring together with atoms to which they are attached, a plurality of R^{XT1}' may be the same or different and may be combined together to form a ring together with atoms to which they are attached,
Ring R^{T1} and Ring R^{T2} each independently represent an aromatic hydrocarbon ring or a hetero ring, and these rings optionally have a single or a plurality of substituents, when a plurality of said substituents are present, they may be the same or different and may be combined together to form a ring together with atoms to which they are attached,
at least one of Ring R^{T1} and Ring R^{T2} is a hetero ring containing a group represented by =N- in the ring and the ring optionally has a single or a plurality of substituents, and when a plurality of said substituents are present, they may be the same or different and may be combined together to form a ring together with atoms to which they are attached.

8. The light emitting device according to Claim 7, wherein said Ring R^{T1} is an aromatic hydrocarbon ring or a hetero ring containing a group represented by =N- in the ring and these rings optionally have a single or a plurality of substituents, and said Ring R^{T2} is a hetero ring containing a group represented by =N- in the ring and the ring optionally has a single or a plurality of substituents.

9. The light emitting device according to Claim 8, wherein said Ring R^{T1} is a monocyclic aromatic hydrocarbon ring or a monocyclic hetero ring containing a group represented by =N- in the ring and these rings optionally have a single or a plurality of substituents, and said Ring R^{T2} is a monocyclic hetero ring containing a group represented by =N- in the ring and the ring optionally has a single or a plurality of substituents.

10. The light emitting device according to Claim 9, wherein said Ring R^{T1} is a benzene ring, a pyridine ring or a diazabenzene ring and these rings optionally have a single or a plurality of substituents, and said Ring R^{T2} is a pyridine ring or a diazabenzene ring and these rings optionally have a single or a plurality of substituents.

11. The light emitting device according to any one of Claims 1 to 10, wherein
said light emitting device further has a third layer disposed between said anode and said cathode, and
said third layer is a layer containing a metal complex represented by the formula (1): 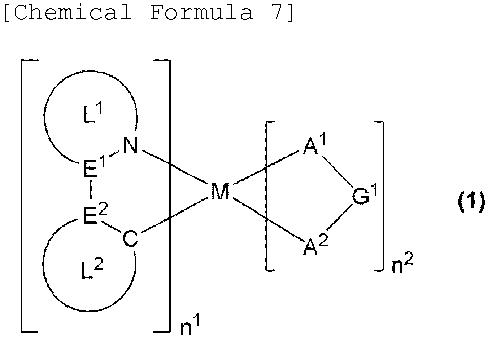 wherein,
M represents a rhodium atom, a palladium atom, an iridium atom or a platinum atom,
n¹ represents an integer of 1 or more, n² represents an integer of 0 or more, n¹+n² is 3 when M is a rhodium atom or an iridium atom, while n¹+n² is 2 when M is a palladium atom or a platinum atom,
E¹ and E² each independently represent a carbon atom or a nitrogen atom, when a plurality of E¹ and E² are present, they may be the same or different at each occurrence,
Ring L¹ represents an aromatic hetero ring, and this ring optionally has a single or a plurality of substituents, when a plurality of the substituents are present, they may be the same or different and may be combined together to form a ring together with atoms to which they are attached, when a plurality of Ring L¹ are present, they may be the same or different,
Ring L² represents an aromatic hydrocarbon ring or an aromatic hetero ring, and these rings optionally have a single or a plurality of substituents, when a plurality of the substituents are present, they may be the same or different and may be combined together to form a ring together with atoms to which they are attached, when a plurality of Ring L² are present, they may be the same or different,
the substituent which Ring L¹ optionally has and the substituent which Ring L² optionally has may be the same or different and may be combined together to form a ring together with atoms to which they are attached,
A¹-G¹-A² represents an anionic bidentate ligand, A¹ and A² each independently represent a carbon atom, an oxygen atom or a nitrogen atom, and these atoms may be ring constituent atoms, G¹ represents a single bond, or an atomic group constituting a bidentate ligand together with A¹ and A², when a plurality of A¹-G¹-A² are present, they may be the same or different.

12. The light emitting device according to Claim 11, wherein
said Ring L¹ is a pyridine ring, a diazabenzene ring, an azanaphthalene ring, a diazanaphthalene ring, a diazole ring or a triazole ring and these rings optionally have a single or a plurality of substituents, and said Ring L² is a benzene ring, a pyridine ring or a diazabenzene ring and these rings optionally have a single or a plurality of substituents.

13. The light emitting device according to Claim 11 or 12, wherein
said third layer further contains a compound represented by the formula (H-1): 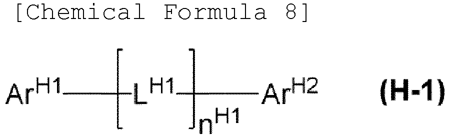 wherein,
Ar^{H1} and Ar^{H2} each independently represent an aryl group, a monovalent hetero ring group or a substituted amino group, and these groups optionally have a single or a plurality of substituents, when a plurality of said substituents are present, they may be the same or different and may be combined together to form a ring together with atoms to which they are attached,
n^{H1} represents an integer of 0 or more,
L^{H1} represents an arylene group, a divalent hetero ring group, an alkylene group or a cycloalkylene group, and these groups optionally have a single or a plurality of substituents, when a plurality of said substituents are present, they may be the same or different and may be combined together to form a ring together with atoms to which they are attached, when a plurality of L^{H1} are present, they may be the same or different.

14. The light emitting device according to any one of Claims 11 to 13, wherein
said third layer is a layer disposed between said second layer and said first layer.

15. The light emitting device according to Claim 14, wherein
said third layer and said first layer are adjacent, and said third layer and said second layer are adjacent.
